(19) Europäisches Patentamt / European Patent Office / Office européen des brevets

(11) **EP 2 005 251 B1**

(12) **EUROPÄISCHE PATENTSCHRIFT**

(45) Veröffentlichungstag und Bekanntmachung des Hinweises auf die Patenterteilung:
**02.11.2011 Patentblatt 2011/44**

(21) Anmeldenummer: **07727797.8**

(22) Anmeldetag: **04.04.2007**

(51) Int Cl.:
*G03F 7/20* (2006.01)          *G03H 1/08* (2006.01)

(86) Internationale Anmeldenummer:
**PCT/EP2007/053328**

(87) Internationale Veröffentlichungsnummer:
**WO 2007/116000 (18.10.2007 Gazette 2007/42)**

(54) **VORRICHTUNG UND VERFAHREN ZUR STEUERUNG EINER VORRICHTUNG ZUR MIKROSTRUKTURIERUNG EINES SPEICHERMEDIUMS**

DEVICE AND METHOD OF CONTROLLING A DEVICE FOR MICROSTRUCTURING A STORAGE MEDIUM

DISPOSITIF ET PROCÉDÉ DE COMMANDE DE MICROSTRUCTURATION D'UN SUPPORT D'ENREGISTREMENT

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **04.04.2006 DE 102006015609**

(43) Veröffentlichungstag der Anmeldung:
**24.12.2008 Patentblatt 2008/52**

(60) Teilanmeldung:
**08105973.5 / 2 071 401**

(73) Patentinhaber: **tesa scribos GmbH**
**69126 Heidelberg (DE)**

(72) Erfinder:
• **NOEHTE, Steffen**
**69469 Weinheim (DE)**
• **THOMANN, Robert**
**69121 Heidelberg (DE)**

(74) Vertreter: **Cohausz & Florack**
**Patent- und Rechtsanwälte**
**Partnerschaftsgesellschaft**
**Bleichstraße 14**
**40211 Düsseldorf (DE)**

(56) Entgegenhaltungen:
**EP-A- 0 453 946          WO-A-03/016977**
**WO-A-2004/059394        DE-A1- 3 512 615**
**DE-A1- 19 939 088        US-A- 4 826 299**
**US-A1- 2005 219 502      US-B1- 6 177 980**
**US-B1- 6 414 326         US-B2- 6 552 830**

• **THOMANN R C ET AL: "Vibration non-sensitive lithographic system for writing individualized holograms for data storage and security applications", PROCEEDINGS OF THE SPIE - THE INTERNATIONAL SOCIETY FOR OPTICAL ENGINEERING SPIE-INT. SOC. OPT. ENG. USA, vol. 5751, no. 1, 2005, pages 619-628, ISSN: 0277-786X**

**Beschreibung**

Die Erfindung betrifft eine Vorrichtung und ein Verfahren zur Steuerung einer Vorrichtung zur Mikrostrukturierung eines Speichermediums.

Mikrostrukturierungen der eingangs genannten Art sind aus dem Stand der Technik bekannt und bestehen aus einer Mehrzahl von Punkten und/oder Linien, mit denen eine Oberfläche oder eine oder mehrere Schichten eines Speichermediums in einer optischen Eigenschaft verändert wird. Dabei können eine Änderung der Reflektivität, Transmission, Absorption, Streuverhalten, eine Änderung der Phase des reflektierten Lichtes oder eine Kombination aller Effekte ausgenutzt werden. Die räumliche Auflösung kann dabei weniger als 10 $\mu$m bis hinunter zu Punkt- oder Linienabmessungen von weniger als 1 $\mu$m betragen. Derartige Mikrostrukturierungen werden zur Speicherung von Informationen verwendet, insbesondere können computergenerierte Hologramme, Mikrobilder oder Mikroschriften damit erzeugt werden.

Computergenerierte Hologramme bestehen aus einer oder mehreren Schichten von Punktematrizen bzw. Punkteverteilungen, die bei einer Beleuchtung mit einem vorzugsweise kohärenten Lichtstrahl zu einer Rekonstruktion der in dem Hologramm einkodierten Informationen führen. Die Punkteverteilung kann dabei als Amplitudenhologramm, Phasenhologramm oder als Kinoform Fresnell- oder Fourierhologramm berechnet sein. Zur Herstellung von computergenerierten Hologrammen werden diese zuerst berechnet und anschließend mit einer geeigneten Schreibvorrichtung durch punktweises Einbringen von Energie in ein Speichermedium eingeschrieben. Die Auflösung der dabei entstehenden Punktematrix kann, wie bereits angesprochen, im Bereich bis unterhalb von 1 $\mu$m liegen. Somit können auf engem Raum Hologramme mit einer hohen Auflösung geschrieben werden, deren Information erst durch Beleuchten mit einem Lichtstrahl und Rekonstruieren des Beugungsbildes ausgelesen werden können. Die Größe der Hologramme kann dabei zwischen wenigen 1 mm$^2$ und mehreren 1 cm$^2$ betragen.

Ein großer Vorteil der computergenerierten Hologramme liegt darin, dass jedes Holgramm ohne großen Aufwand individuell berechnet werden kann. Somit können in Serie Hologramme erzeugt werden, die beispielsweise fortlaufende Nummern oder Produktionsparameter beinhalten. Derartige Hologramme können daher insbesondere als Sicherheitsmerkmale oder in der Logistik zur Produktverfolgung auf Verpackungen, Kreditkarten, Eintrittskarten oder ähnlichem eingesetzt werden. Mit einer geeigneten Auslesevorrichtung können die Sicherheitsmerkmale des Hologramms ausgelesen und die Authentizität und Individualität des Sicherheitsmerkmals kann in einfacher Weise überprüft werden.

Die zuvor beschriebenen computergenerierten Hologramme können mit einer direkt sichtbaren Information kombiniert werden (Mikroschrift, Mikrobilder). Daneben können mit einer eingangs genannten Mikrostrukturierung auch die erwähnten Mikrobilder und Mikroschriften selber unabhängig von computergenerierten Hologrammen eingeschrieben werden. Die Punkteverteilungen können auch als Dotmatrixhologramme erzeugt werden, wobei jeweils einzelne kleine Flächenabschnitte als unterschiedliche Beugungsstrukturen des Dotmatrixhologramms erzeugt werden. Daneben ist es auch möglich, mit der Mikrostrukturierung ein diffraktives optisches Element (DOE) an sich zu erzeugen.

Wenn im Folgenden das Schreiben oder Auslesen mit einem Lichtstrahl beschrieben wird, ist in der Regel ein Laserstrahl im sichtbaren Wellenlängenbereich gemeint. Dennoch ist die vorliegende Erfindung nicht auf die Anwendung sichtbaren Lichtes beschränkt. Im Prinzip kann die Erfindung mit elektromagnetischer Strahlung in einem weiten Wellenlängenbereich angewendet werden.

Aus dem Stand der Technik sind des Weiteren eine Mehrzahl von Schreibvorrichtungen zum Schreiben von computergenerierten Hologrammen bekannt, die in ebenen Speichermedien die optischen Strukturen der Holgramme einschreiben. Beispielhaft wird dazu auf die Druckschriften WO 02/079881, WO 02/079883, WO 02/084404, WO 02/084405 und WO 03/012549 hingewiesen. Diese Schreibvorrichtungen verwenden einen Laserstrahl, der nacheinander jeden einzelnen Punkt der Punktematrix abscannt und wahlweise Lichtenergie in das Speichermedium einbringt oder nicht.

Ebenso sind eine Mehrzahl von Lesevorrichtungen bekannt, die geeignet sind, durch Beleuchten der Hologrammfläche mittels eines Lichtstrahls und einer geeigneten Optik die Rekonstruktion sichtbar oder mittels Aufnahmemitteln elektronisch darstellbar und auswertbar zu machen. Beispielhaft wird dabei auf die Druckschriften DE 101 37 832, WO 02/084588 und WO 2005/111913 verwiesen.

Die EP 1 094 352 A2 offenbart dagegen eine optische Schreibvorrichtung zur Bilderzeugung mit einer Lichtquelle bestehend aus einer Mehrzahl von in einer Reihe angeordneten Laserdioden. Das von dieser Lichtquelle emittierte Licht wird mittels einer Optik auf einen Grating Light Valve (GLV) der Firma Silicon Licht Machines gerichtet, mit dem für jeden Punkt des GLV eine Beugung stattfindet. Das GLV kann auch als Zeilenlichtmodulator bezeichnet werden. Durch sukzessive Belichtung entsteht zeilenweise ein Bild. Die mittels der Schreibvorrichtung erzeugte Auflösung im geschriebenen Bild wird mit 2400 dpi entsprechend einer Punktgröße von ca. 10 $\mu$m angegeben.

Die DE 198 02 712 A1 offenbart eine Vorrichtung zum Belichten eines computergenerierten Hologramms auf einem Speichermedium. Der aufbereitete Laserstrahl trifft auf einen digitalen Lichtprozessor (DLP), mit dem das 2D-Lichtfeld auf das Speichermedium abgelenkt wird. Mit den kleinflächigen Einzelspiegeln des DLP werden Strukturen in einem Speichermedium erzeugt. Die Hologrammgröße wird daher vom verwendeten DLP und der Skalierung der Abbildung bestimmt.

Aus der US2005/0219502 ist eine Vorrichtung zum Belichten einer Halbleiterstruktur auf einem Wafer bekannt, die zu diesem Zweck eine Strahlungsquelle zur Erzeugung eines Laserstrahls aufweist, welcher über eine Optik auf einen Modulator geleitet wird. Der Modulator reflektiert den Laserstrahl je nach Stellung der einzelnen Modulatorelemente. Der vom Modulator reflektierte Laserstrahl fällt zunächst über eine Verkleinerungsoptik, in der die Phasenmodulation in eine Intensitätsmodulation umgewandelt wird. Anschließend gelangt der Laserstrahl auf den Wafer, der auf einem Transporttisch angeordnet ist und so in zwei Raumrichtungen gegenüber der Verkleinerungsoptik verschoben werden kann. Beim Belichten des Wafers werden der Laser, der Modulator und die Position des Wafers synchronisiert.

Die EP 1 202 550 A1 zeigt eine Schreibvorrichtung mit einem Zeilenlichtmodulator (GLV) und mit einer Abbildungsoptik. Im Strahlengang des Laserstrahls ist ein Polarisator angeordnet, der eine lineare Polarisierung des Strahls erzeugt. Dadurch wird die bevorzugte Richtung des Zeilenlichtmodulators ausgenutzt, so dass größere Intensitäten auf dem Schreibmedium erreicht werden. Damit wird das Schreiben von photosensitiven und wärmesensitiven Materialien beschleunigt.

Die EP 1 480 441 A1 zeigt einen Aufbau einer Schreibvorrichtung mit einem Strahlvervielfacher, der aus einem single-mode Laserstrahl eine Vielzahl von Einzelstrahlen erzeugt. Diese treffen dann auf einen vielkanaligen Raumlichtmodulator, die dort einzeln moduliert werden. Die einzelnen vom SLM reflektierten Strahlen sind jeder im wesentlichen single-mode Strahlen und die nachfolgende Optik bildet diese Mehrzahl von Einzelstrahlen auf die Oberfläche eines lichtempfindlichen Werkstückes ab. Das beschriebene Verfahren dient beispielsweise einer Herstellung von Schaltkreisen.

Aus der WO 01/79935 ist eine Vorrichtung bekannt, mit der Photomasken für Halbleiterelemente und Anzeigevorrichtungen erzeugt werden können. Ebenso können Halbleiterelemente, Anzeigen, integrierte optische Elemente und elektronische Verbindungsstrukturen direkt geschrieben werden. Zum Erzeugen einzelner Punkte wird im Strahlengang eines Laserstrahls ein räumlicher Lichtmodulator (spatial light modulator - SLM). Die nachfolgende Abbildungsoptik bildet dann den Lichtmodulator auf dem Speichermedium ab, um die Struktur zu schreiben. Um eine Energie-Fluktuation zwischen den einzelnen Schreibpulsen zu beherrschen und somit ein gleichmäßiges Schreiben der Struktur zu ermöglichen, wird vorgeschlagen, eine sehr schnelle Steuerung eines Schalters zu verwenden, die noch während eines Laserpulses ein Abschalten der Lichtenergie ermöglicht. Die WO 01/79935 geht dabei von einer mittleren Schreibenergie von 10-100 mW aus.

Die zuvor beschriebenen Systeme haben jeweils mindestens eines der nachfolgenden Probleme. So weisen die Systeme entweder eine zu geringe örtliche Auflösung und Genauigkeit der geschriebenen Strukturierung, einen zu geringen Durchsatz bzw. Schreibgeschwindigkeit, keine individuell erzeugbaren Strukturen oder eine zu geringe Schreibenergie auf, um auch wenig photo- oder wärmeempfindliche Materialien strukturieren zu können.

Systeme der zuvor beschriebenen Art benötigen für den laufenden Betrieb eine aktive Autofokussierung, um relative Abweichungen zwischen der Abbildungsoptik und dem Speichermedium zu korrigieren. Ein Problem für ein sehr genaues und schnell arbeitendes Autofokussystem besteht dabei darin, dass die Strukturierung eines Speichermaterials mit einer Auflösung im Bereich der Wellenlänge bzw. mit entsprechender Numerischer Apertur (NA) eine aktive Höhenregelung notwendig macht. Dies resultiert aus der begrenzten Tiefenschärfe die mit der verwendeten NA wie folgt zusammenhängt

$$\Delta z = 0.8 \frac{\lambda}{NA^2} \; .$$

Hier ist zu sehen, dass mit zunehmender NA, was kleinere Strukturen bedeutet, die Tiefenschärfe $\Delta z$ quadratisch reziprok abnimmt. Für Strukturen im sichtbaren Wellenlängenbereich und bei Strukturgrößen von etwa $1 \mu m$ errechnet sich somit eine Tiefenschärfe im einstelligen Mikrometerbereich. Aufgrund von Fertigungstoleranzen des Speichermediums bzw. aufgrund von Ungenauigkeiten durch die Halterung des Speichermediums ist mit einer Höhenvariation des Speichermaterials im zweistelligen Mikrometerbereich zu rechnen. Dies macht eine aktive Höhenregelung notwendig.

Die Forderung an die Höhenregelung besteht darin, den Schreibstrahl auf seinem gesamten Bereich innerhalb der Tiefenschärfe zu halten. Bei aus dem Stand der Technik bekannten Systemen ging man davon aus, dass sich die Höhe innerhalb der Belichtungsbreite bzw. -bereichs nur gering ändert und somit eine Einpunkt-Höhenregelung ausreicht. Experimente haben aber immer wieder gezeigt, dass es aufgrund von Ungenauigkeiten in der Fertigung und durch Dejustage der Proben- bzw. Speichermaterialhalterung zu unstrukturierten Stellen, insbesondere am Rande der Belichtung kommt. Daraus resultiert die Forderung nach einer Höhenregelung über den gesamten Belichtungsbereich, die umso dringlicher wird, je größer der Belichtungsbereich wird.

Der vorliegenden Erfindung liegt daher das technische Problem zugrunde, Mikrostrukturierungen und individuelle diffraktive optische Elemente (DOE), insbesondere computergenerierte Hologramme mit hoher Geschwindigkeit, hoher Präzision und mit hoher Schreibenergie schreiben zu können.

Ein weiteres technisches Problem besteht darin, ein System anzugeben, mit dem man Punkt- bzw.

Linienstrukturen mit einer Strukturgröße im Mikrometerbereich (50 $\mu m$ bis 1 $\mu m$) oder im Submikrome-

terbereich (1.0 µm bis 0.01 µm) schreiben kann.

Ein weiteres technisches Problem besteht darin, ein System anzugeben, mit dem man Punkt- bzw. Linienstrukturen mit hoher Geschwindigkeit (typisch 100 MPunkte/s) oder höher schreiben kann.

Ein weiteres technisches Problem besteht darin, ein System anzugeben, mit dem großflächige Mikrostrukturierungen im Bereich von 1 mm$^2$ bis 1 m$^2$, typisch 1 cm$^2$ geschrieben werden können.

Ein weiteres technisches Problem besteht darin, ein System zu anzugeben, mit dem Mikrostrukturierungen in ein optisch wenig empfindliches Material (z. B. dünne Aluminiumschichten, Metalle, Polymere, seltene Erden) geschrieben werden können.

Mindestens eines, bevorzugt mehrere der zuvor genannten technischen Probleme werden durch eine Vorrichtung mit den Merkmalen des Anspruches 1 gelöst. Diese Vorrichtung weist auf:

- eine Strahlungsquelle zum Erzeugen eines zumindest teilweise kohärenten Strahls aus elektromagnetischer Strahlung,
- einen Modulator mit einer Mehrzahl von einzeln schaltbaren Modulatorelementen,
- eine Strahlformungsoptik zum Ausleuchten des Modulators,
- eine Verkleinerungsoptik zum Verkleinern des vom Modulator abgestrahlten Strahls
- eine Anordnung zur Umwandlung der Phasenmodulation in eine Intensitätsmodulation (z. B. Ortsfrequenzfilter)
- eine Transportvorrichtung zum Bewegen des Speichermediums relativ zur Verkleinerungsoptik
- wobei die Verkleinerungsoptik ausgehend von der Flache der einzelnen Modulatorelemente eine Flächenverkleinerung von mindestens 25 erzeugt,
- wobei die Transportvorrichtung als Transporttisch ausgebildet ist
- wobei eine den Laser, den Modulator und den Transporttisch synchronisierende Steuerung vorgesehen ist.
- wobei die Verkleinerungsoptik beugungsbegrenzt ausgebildet ist,
- wobei Mittel zum Erzeugen eines Mastertriggers $T_0$ um eine vorgegebene Zeitdauer AT vor dem Erreichen der Position einer neuen in dem Speichermedium zu schreibenden Strukturierung während der Bewegung des Transporttisches vorgesehen sind,
- wobei Mittel zum Ansteuern der Strahlungsquelle zum Erzeugen eines Strahlungsimpulses im Zeitpunkt $T_0$+ $\Delta T$ vorgesehen sind,
- wobei Mittel zum Einstellen des Modulators vor Erreichen des Zeitpunktes $T_0$ + $\Delta T$ entsprechend der zu schreibenden Informationen vorgesehen sind und
- wobei Mittel zum Erzeugen eines Strahlungsimpuls durch die Strahlungsquelle im Zeitpunkt $T_0$ + $\Delta T$ vorgesehen sind.

Erfindungsgemäß ist die Verkleinerungsoptik beugungsbegrenzt ausgebildet und die Verkleinerungsoptik erzeugt ausgehend von der Fläche der einzelnen Modulatorelemente eine Flächenverkleinerung von mindestens 25.

Durch die Strahlformungsoptik werden die einzelnen Modulatorelemente jeweils mit einer ebenen Welle oder einer annähernd ebenen Welle bestrahlt, so dass durch die beugungsbegrenzte Verkleinerungsoptik ein optimales Ergebnis, also sehr kleine Durchmesser der einzelnen verkleinerten Punkte erreicht werden. Für eine Abgrenzung der Unebenheit einer Welle kann das Raileigh-Kriterium herangezogen werden, das besagt, dass über jedes Modulatorelement hinweg die Abweichung von der ebenen Welle nicht größer als λ/4 ist, mit λ der Wellenlänge des Lichtes.

Durch die Verwendung eines parallel arbeitenden Modulators, beispielsweise eines Zeilenlichtmodulators, können in einem Belichtungsschritt eine Vielzahl von einzelnen Punkten oder Linien einer individuellen Struktur in das Speichermedium geschrieben werden. Dabei bringen die beugungsbegrenzte Verkleinerungsoptik und die damit verbundene starke Verkleinerung die Möglichkeit, sehr kleine Strukturen mit hoher Schreibenergie schreiben zu können. Dadurch wird schnelles und massiv paralleles ein Schreiben von Mikrostrukturierungen in Materialien möglich, die bisher nicht beschrieben werden konnten. Durch die Verkleinerung von typisch 250 bzw. mindestens 25 und beugungsbegrenzter Strahlführung können hohe Energiedichten mit dem Modulator gesteuert werden, die ansonsten der Modulator selbst zerstören würden.

Ohne nachgelagerten Entwicklungsschritt können somit schnell und kostengünstig DOE, insbesondere computergenerierte Hologramme hergestellt werden, die zudem individuell und im Mikrometer- bzw. Submikrometerbereich erzeugt werden können. Die Schreibgeschwindigkeit kann bis zu beispielsweise 100 MPunkte/sec erreichen. Ein weiterer Vorteil besteht darin, dass eine hohe Positioniergenauigkeit der diffraktiven Belichtungspunkte erreicht werden kann. Schließlich kann die Mikrostrukturierung durch eine geeignete Ansteuerung des Modulators auch mit unterschiedlicher Intensität, also beispielsweise mit unterschiedlichen Graustufen geschrieben werden.

Der Begriff der Beugungsbegrenzung wird nach DIN ISO 10110-5 wie folgt beschrieben. Ein Maß für die Abbildungsqualität eines Systems ist die "Strehlsche Definitionshelligkeit" oder das "Strehlsche Intensitätsverhältnis", also das Verhältnis der Intensität in der Mitte des Punktbildes zu derjenigen Intensität, die für das aberrationsfreie optische System definiert ist. Damit wird ausgesagt, wie viel Licht im Vergleich zu dem theoretisch möglichen Licht im Beugungsscheibchen, auch Airy-Scheibchen genannt, vereint wird und wie viel Licht sich außerhalb befindet. Ein Strehl-Wert von 1 entsprechend 100% bedeutet, dass das Licht, das innerhalb des Beugungsscheibchens vorliegt, den theoretisch maximalen Wert erreicht. Ein solches System wäre frei von Abbildungsfehlern. Optiken mit einem Strehl-Wert besser 0,8 gelten nach dieser Norm als beugungsbegrenzt.

Die Betrachtungsweise nach Strehl ist darauf gerichtet, die Intensitätsverteilung im Fokus bezogen auf das Beugungsscheibchen zu vermessen. Es gibt eine weitere Möglichkeit zur Bestimmung der Beugungsbegrenzung, die sich jedoch auf die Form bzw. auf die Abmessung des Beugungsscheibchens bezieht. Dazu existiert die Formel

$$d = \lambda / NA$$

mit

   d - dem Durchmesser des Beugungsscheibchens gemessen als Abstand zwischen den Beugungsminima zu beiden Seiten des Beugungsscheibchens,
   $\lambda$ - der Wellenlänge des fokussierten Lichts und NA - der numerischen Apertur der Verkleinerungsoptik.

Weicht nun die Abmessung des Beugungsscheibchens um weniger als 20 % von diesem Wert d gemäß der genannten Formel zu größeren Werten hin ab, dann ist die verwendete Optik beugungsbegrenzt.

Bevorzugt ist es weiterhin, dass die Flächenverkleinerung der Verkleinerungsoptik zwischen 25 und 1000, vorzugsweise zwischen 50 und 1000, insbesondere 250 beträgt. In diesem Wertebereich können besonders kleine und intensive Lichtstrukturen bzw. Lichtpunkte zeilenweise oder flächig erzeugt werden, die in der Lage sind, auch weniger lichtempfindliche Materialien ausreichend verändern zu können, um eine Mikrostrukturierung zu erzeugen. Beispiele für solche Materialien sind dünne Aluminiumschichten, Metalle, Polymere, seltene Erden, in denen durch punktweises Einbringen von Energie Umstrukturierungen, Verdrängungsprozesse, Kondensationsprozesse, Ablationsprozesse oder Verdampfungsprozesse ausgelöst werden.

In weiter bevorzugter Weise verkleinert die Verkleinerungsoptik die von jedem Modulatorelement gebeugte Strahlungsintensität auf eine Größe von weniger als 10 µm Durchmesser, insbesondere weniger als 1 µm Durchmesser. Dadurch können Mikrostrukturen mit einer Auflösung erzeugt werden, die insbesondere bei weniger photoempfindlichen Materialien bisher nicht erreichbar gewesen sind.

In vorteilhafter Weise ist die Strahlungsquelle als Laser ausgebildet. Diese Ausgestaltung der Lichtquelle stellt aber keine Beschränkung der Erfindung dar. Jedoch ergibt sich aus dem Stand der Technik bereits, dass der Laser das bevorzugte Mittel zur Erzeugung eines zumindest teilweise kohärenten Strahls elektromagnetischer Strahlung ist. Vorzugsweise wird ein gepulster Laser eingesetzt, dessen Pulse eine höhere Energiedichte als der Laserstrahl eines Dauerstrichlasers aufweist.

Ein typisches Beispiel für einen gepulsten Laser kann so charakterisiert werden, dass die Pulsdauern im Nanosekundenbereich liegen und dass die Energie eines Pulses im Bereich von 100 Mikrojoule liegt. Das bedeutet bei 1024 Punkten eines Zeilenlichtmodulators eine Energie pro Puls und Modulatorelement von ungefähr 0,1 Mikrojoule. Dadurch ist eine ausreichende Energiedichte für Materialstrukturierung gegeben, die nur im geringen Maße von der Wärmeleitfähigkeit des Materials abhängt.

Die Art der Erzeugung der Mikrostrukturen wird daher optimal verwirklicht, wenn hochenergetische Laserpulse im sichtbaren oder angrenzenden Wellenlängenbereichen eingesetzt werden, um das Speichermedium zu mikrostrukturieren. Dadurch ergibt sich ein breiteres Spektrum der zu verwendeten Materialien. Die Verwendung eines cw-Lasers ist dabei prinzipiell möglich, aber wegen der geringeren Energiedichte nicht so vorteilhaft.

Weiterhin ist es bevorzugt, dass der Laser einen monomoden Laserstrahl erzeugt, so dass einerseits die Kohärenzeigenschaften des Lichtstrahls optimal sind und andererseits eine regelmäßige Intensitätsverteilung des Laserstrahls quer zur Ausbreitungsrichtung vorliegt.

Dagegen kann es auch ausreichen, wenn der Laser einen multimoden Laserstrahl mit partieller Kohärenz erzeugt. Auch wenn die Intensitätsverteilung des erzeugten Laserstrahls nicht optimal ist und ggf. ausgeglichen werden muss, so reicht es aus, wenn der auf den Modulator gerichtete Strahl eine zumindest über einige Modulatorelemente hinweg reichende räumliche Kohärenz aufweist. Es kommt also nicht darauf an, dass alle Modulatorelemente mit zueinander kohärentem Licht bestrahlt werden.

Als Beispiel für ein gepulstes Lasersystem wird ein diodengepumpter Festkörperlaser im sichtbaren Spektralbereich genannt.

Ein wesentliches Element zum Erzeugen eines intensitätsmodulierten Strahls stellt der bereits erwähnte Modulator dar. Die einzelnen Modulatorelemente können elektronisch gesteuert werden, um zumindest jeweils eine von zwei möglichen Einstellungen einzunehmen. Allgemein ist der Modulator stufenlos schaltbar und wirkt als örtlicher Phasenmodulator. Dabei können einzeilige oder auch zweidimensionale Modulatoren eingesetzt werden. Letztere haben aber den Nachteil, dass eine zweidimensionale Ausleuchtung der Fläche des Modulators erforderlich ist, die schwieriger als eine eindimensionale Ausleuchtung ist. Ein weiterer Nachteil ist, dass sich Interferenzeffekte bei zweidimensionaler Belichtung bei bestimmten Aufbauten der Speichermedien stärker ausprägen. Somit stellt es eine Vereinfachung des Systems dar, wenn ein einzeiliger Aufbau gewählt wird und eine Homogenisierung der Strahlintensität nur in einer Dimension notwendig ist.

Als besonders bevorzugtes Ausführungsbeispiel eines Modulators hat sich daher ein einzeiliger, aus separat schaltbaren Modulatorelementen bestehender Zeilenlichtmodulator herausgestellt. Wird dieser Zeilenlichtmodulator nacheinander schrittweise so angesteuert, dass nach jeder neuen Einstellung jeweils eine andere Intensitätsverteilung erzeugt wird, so können nacheinander unterschiedliche Mikrostrukturierungszeilen in das Speichermedium geschrieben werden. Daraus entsteht eine Fläche bzw. ein Bereich mit einer Mikrostrukturierung, die individuell gestaltet werden kann. Denn für jeden Schreibvorgang muss der Lichtmodulator neu angesteuert werden, somit kann er auch für jeden Schreibvorgang unterschiedlich angesteuert werden.

Die Linienstruktur des Flächenlichtmodulators wird bevorzugt senkrecht zur Scannbewegung auf das Speichermedium abgebildet, um eine möglichst große Breite des geschriebenen Streifens zu erreichen. Eine modifizierte Ausführung sieht eine nicht orthogonale Orientierung vor. Dadurch kann eine feinere Auflösung bei allerdings reduzierter Schreibbreite erzielt werden.

Ein Beispiel für einen einzeiligen Lichtmodulator ist ein Grating Light Valve (GLV) der Firma Silicon Light Machines, CA, USA. Dieser Zeilenlichtmodulator weist separat schaltbare Diffraktionsgitter auf. Jedes Modulatorelement weist mehrere parallel zueinander verlaufende und in einer Ebene angeordnete Bänder auf, von denen beispielsweise jedes zweite Band elektrostatisch aus der Ebene heraus verstellt werden kann. Somit wirkt das Modulatorelement entweder als Spiegel oder als kleines Beugungsgitter, das die Lichtintensität in eine von der Reflektionsrichtung abweichende Richtung beugt. Dadurch kann jedes Modulatorelement je nach Ansteuerung das auftreffende Licht unterschiedlich stark in Reflektions- bzw. Beugungsrichtung ablenken.

Die bereits erwähnte Strahlformungsoptik dient einer Ausleuchtung des einzeiligen oder zweidimensionalen Lichtmodulators. Dabei ist es angestrebt, dass die Ausleuchtung des Modulators möglichst gleichförmig ist, damit eine homogene Intensitätsverteilung erreicht wird, die bei gleicher Ansteuerung der einzelnen Modulatorelemente zu gleichen Schreibintensitäten auf dem Speichermedium führen. Allgemein ausgedrückt soll also die Strahlformungsoptik aus dem von der Strahlungsquelle erzeugten Strahlprofil ein auf die Fläche des Modulators angepasstes Strahlprofil erzeugen.

Dabei ist es bei der Verwendung eines Zeilenlichtmodulators bevorzugt, dass die Strahlformungsoptik eine Powell Linse aufweist. Eine Powell Linse ist aus der US 4,826,299 bekannt und erzeugt beispielsweise aus einer Gauß'schen Intensitätsverteilung eine im wesentlichen an eine Rechteckform angenäherte Intensitätsverteilung.

Somit wird eine Strahlformungsoptik verwendet, deren Funktion es ist, aus dem Strahlprofil der Lichtquelle bzw. des Lasers ein auf die Geometrie des Zeilenlichtmodulators angepasstes Strahlprofil zu generieren.

Eine weitere bevorzugte Ausgestaltung der Vorrichtung besteht darin, dass die Verkleinerungsoptik ein Mikroskopobjektiv ist. Damit kann eine herkömmliche Technik eingesetzt werden, um die vom Modulator erzeugte Intensitätsverteilung auf das Speichermedium zu fokussieren und zu verkleinern.

Vorzugsweise weist die Verkleinerungsoptik mindestens zwei Objektive mit unterschiedlicher Brennweite und/oder numerischer Apertur auf. Dazu kann beispielsweise ein Wechselmikroskopobjektiv eingesetzt werden, so dass ohne großen Kostenaufwand einer speziellen Entwicklung die bei Lichtmikroskopen verwendeten Objektive eingesetzt werden können. Durch eine Veränderung der Brennweite oder numerischen Apertur kann die Größe der einzelnen Strukturen bzw. Punkte in einfacher Weise verändert werden. Bei Anwendung einer Wechseloptik wird dann ein leichtes Umschalten zwischen unterschiedlichen Strukturgrößen und Rastermaß möglich. Man kann auch von einer schnellen Änderung des Rastermaßes sprechen. Dabei wird durch eine Änderung der Brennweite der Optik das Rastermaß, also der Abstand der einzelnen Punkte zueinander verändert, während die Änderung der numerischen Apertur die Punktgröße verändert. Daher ändern sich bei einem Wechsel des Objektivs das Rastermaß und die Punktgröße nicht in gleicher Weise.

Es ist weiterhin bevorzugt, dass die Verkleinerungsoptik einen Ortsfrequenzfilter aufweist. Die Funktion des Ortsfrequenzfilters ist es, eine Phasenmodulation in eine Intensitätsmodulation umzuwandeln. Der Ortsfrequenzfilter ist dabei bevorzugt mit der Verkleinerungsoptik kombiniert, wobei die erforderliche Lochblende innerhalb der Verkleinerungsoptik angeordnet ist.

Die Verkleinerungsoptik mit kombiniertem Ortsfrequenzfilter stellt also nichts anderes dar, als einen Filter in Form einer Lochblende in der Fourierebene anzuordnen, um die Phasenmodulation des Modulators, insbesondere des Zeilenlichtmodulators, in eine Intensitätsmodulation im Schreibstrahl umzuwandeln.

Für den Transport des Speichermediums relativ zur Verkleinerungsoptik ist die oben genannte Transportvorrichtung vorgesehen. Bevorzugt ist dabei, dass die Transportvorrichtung als Transporttisch ausgebildet ist und vorzugsweise einachsig, insbesondere zweiachsig verstellbar ist. Somit kann das Speichermedium in beliebiger Richtung quer zur Ausbreitungsrichtung des fokussierten Lichtstrahls bewegt werden. Ebenso kann die Transportvorrichtung auch als Transportband ausgebildet sein.

Eine Bewegung des Speichermediums relativ zum Schreibkopf in zwei Richtungen ermöglicht es, mehrere Spuren einer Mikrostrukturierung nebeneinander zu schreiben und damit größere Flächen bearbeiten zu können.

Der Transporttisch hat dabei in bevorzugter Weise eine hohe Genauigkeit in der Positionsbestimmung, nicht aber im Bewegungsablauf selbst. Durch massiv parallele Belichtung kann die Geschwindigkeit der Bewegung entsprechend verringert sein, denn es kommt nicht auf hohe Geschwindigkeiten beim Bewegen des Speichermediums an. Vorzugsweise wird ein Transporttisch mit einem Rollantrieb, insbesondere mit einem Positionsfeedbacksystem eingesetzt.

Wie weiter unten noch näher erläutert wird, wird die exakte Positionsdetektion zur Triggerung des Schreibprozesses selbst verwendet, der Transporttisch ist also durch seine Bewegung und seine exakte Positionsbestimmung das die Synchronisation des Schreibvorgangs steuernde Mittel. Bei diesem System triggert also die Materialbewegung das Lasersystem und veranlasst die Steuerung, den Modulator mit der nächsten Belichtungsinformation zu versorgen. Durch die Synchronisierung wird insbesondere die Genauigkeit vor allem in großflächigen Belichtungen erhöht.

Dagegen ist es auch möglich, dass eine freilaufende Ansteuerung des Transporttisches eingesetzt wird und zu vorgegebenen Zeiten die Vorrichtung aktiviert wird und zeilen- oder abschnittsweise die Mikrostrukturierung vornimmt.

Ein weiteres bevorzugtes Merkmal besteht darin, dass ein bewegbares optisches Element, insbesondere ein Strahlteiler oder Spiegel im Strahlengang vor der Verkleinerungsoptik zum Verschieben des verkleinerten Intensitätsmusters auf dem Speichermedium vorgesehen ist. Über das Einbringen eines Aktuators, z. B. zur Bewegung des Strahlteilers oder des Spiegels, kann die vom Modulator erzeugte Belichtungszeile bzw. der Belichtungsabschnitt relativ zum Speichermedium bewegt werden.

Wird eine Bewegung entlang der Richtung des Materialtransportes realisiert, so kann dadurch in vorteilhafter Weise eine Schwankung, die unter anderem durch eine Geschwindigkeitsschwankung des Transporttisches hervorgerufen wird, kompensiert werden.

Wird eine Bewegung quer zur Richtung des Materialtransports realisiert, erlaubt dieser Freiheitsgrad, dass Fehler oder Ungenauigkeiten bei der Materialführung kompensiert werden. Unter anderem ist bei einer flächenhaften Belichtung, die sich aus mehreren Belichtungszeilen oder Belichtungsstreifen zusammensetzt, ein gesteuertes Aneinandersetzen der Belichtungszeilen notwendig. Durch ein Erkennen der Position der vorangegangenen Belichtung des Speichermediums, beispielsweise mittels eines unten beschriebenen Kamerasystems, kann durch die Scanvorrichtung ein exaktes Aneinandersetzen der Spuren bzw. Streifen realisiert werden. Allgemein kann eine beliebige Detektionsvorrichtung verwendet werden.

Die Detektion einer Kante oder Markierung kann also mittels einer Kamera detektiert werden. Allerdings kann wegen der eingeschränkten Repetitionsrate der Kamera eine Detektion einer Kante während der Transportbewegung beispielsweise mittels einer Photodetektoranordnung vorteilhaft und damit bevorzugt sein.

Ebenfalls kann mittels einer Bewegung der Belichtungszeile bzw. des Belichtungsabschnittes quer zur Bewegungsrichtung des Speichermediums die Belichtung an eine im Material des Speichermediums vordefinierte Position erfolgen. Dies setzt wiederum eine Detektion der vordefinierten Position, z. B. eine geprägte Markierung oder Spur, voraus, wozu erneut in vorteilhafter Weise das bereits erwähnte Kamerasystem oder die Photodetektoranordnung eingesetzt werden können.

Die Vorrichtung weist also bevorzugt ein Kamerasystem zur Kontrolle der Mikrostrukturierung auf, das in den Strahlengang so integriert ist, dass es mittels einer separaten Beleuchtung die Oberfläche des Speichermediums erfassen und dessen Strukturierung oder Markierung beobachten und zur Auswertung bringen kann. Dazu ist in bevorzugter Weise ein Strahlteiler vorgesehen, durch den einerseits der vom Modulator abgelenkte Strahl und andererseits das Licht aus dem bzw. in den optischen Zweig des Kamerasystems geleitet wird. Für eine weitere Erläuterung wird auf die spezielle Beschreibung verwiesen.

Ebenso kann das Kamerasystem zur Kontrolle einer vorgegebenen Ausrichtung oder eines Alignments relativ zu einer vorgegebenen oder bereits geschriebene Mikrostrukturierung oder Markierung vorgesehen sein. Dieses kann insbesondere für eine verbesserte Aneinanderreihung der Belichtungsstreifen mehrerer Schreibvorgänge genutzt werden.

Es ist eine Steuerung vorgesehen, die den Laser, den Modulator und den Transporttisch synchronisiert. Die Art der Synchronisierung durch die Bewegung des Transporttisches ist bereits oben erwähnt worden, wobei der Transporttisch mit seiner exakten Positionsbestimmung ein Triggersignal erzeugt, das von der Steuerung aufgenommen und weiterverarbeitet wird. Ebenso ist eine freie Bewegung des Transporttisches möglich, wobei die Steuerung dann in geeigneten Zeitabständen entsprechend der Geschwindigkeit des Transporttisches Steuersignale für die Ansteuerung des Lasers und des Modulators erzeugt und an diese sendet. Ebenso kann das Steuersystem auch zur schnellen Datenverarbeitung und Übertragung der Daten auf den Modulator bzw. den Lichtmodulator eingesetzt werden.

Die Steuerung basiert dabei bevorzugt auf zwei gekoppelten Rechnern (Steuerrechner und Datenrechner). Der Steuerrechner stellt die Benuteroberfläche bereit und kontrolliert alle nicht zeitkritischen Abläufe. Darunter fallen alle Initialisierungsaufgaben, Kalibrierungsroutinen, Diagnosetools usw. Der Datenrechner ist für die Bereitstellung der zu verarbeitenden Daten zuständig. Beide Rechner kommunizieren über eine Verbindung miteinander. Zeitkritische Funktionen wie die Triggerung des Lasers und die Ansteuerung des Modulators werden von einer geeigneten Prozessorkarte übernommen. Als zentraler Taktgeber des gesamten lithographischen Systems wird bevorzugt das Positionssignal des Transporttisches, insbesondere des X-Y-Lineartisches herangezogen. Abhängig vom Positionssignal werden die Abläufe während der Belichtung gesteuert.

Die oben aufgezeigten technischen Probleme werden erfindungsgemäß zumindest teilweise durch ein Verfahren zur Steuerung einer zuvor beschriebenen Vorrichtung zur Mikrostrukturierung eines Speichermediums gelöst,

- bei dem während der Bewegung des Transporttisches ein Mastertrigger $T_0$ um eine vorgegebene Zeitdauer $\Delta T$ vor dem Erreichen der Position einer neuen in dem Speichermedium zu schreibenden Strukturierung erzeugt wird,
- bei dem die Strahlungsquelle angesteuert wird, um im Zeitpunkt $T_0 + \Delta T$ einen Strahlungsimpuls zu erzeugen,
- bei dem der Modulator vor Erreichen des Zeitpunktes Zeitpunkt $T_0 + \Delta T$ entsprechend der zu schreibenden Informationen eingestellt wird und
- bei dem die Strahlungsquelle im Zeitpunkt $T_0 + \Delta T$ einen Strahlungsimpuls erzeugt, dessen Intensitätsverteilung entsprechend der Einstellung des Modulators variiert wird.

In der zuvor beschriebenen Weise können nacheinander die jeweiligen Mikrostrukturierungen durch den Modulator bzw. Lichtmodulator erzeugt werden. Insbesondere bei einem linienförmigen einzeiligen Lichtmodulator werden die Punkte der Strukturierung zeilenweise in vorgegebenen Abständen in das Speichermedium eingeschrieben. Dabei kommt es vor allem auf gleich bleibende Abstände zwischen den einzelnen Zeilen an, um eine gleichmäßige Anordnung der Punkte bzw. Zeilen in einem vorgegebenen Raster zu erreichen.

In bevorzugter Weise wird der Transporttisch kontinuierlich bewegt und die Mastertrigger $T_0$ werden durch die Bewegung des Transporttisches um jeweils einen vorgegebenen Abstand erzeugt. In dieser Weise wird der Transporttisch kontinuierlich bewegt und nicht zu einzelnen Bewegungsschritten angesteuert.

Die oben aufgezeigten technischen Probleme werden erfindungsgemäß zumindest teilweise durch ein Verfahren zur Steuerung einer zuvor beschriebenen Vorrichtung zur Mikrostrukturierung eines Speichermediums gelöst,

- bei dem eine erste Strukturierungsspur in einer Schreibrichtung in das Speichermedium eingeschrieben wird,
- bei dem mindestens eine zweite Strukturierungsspur parallel zur vorhergehenden Strukturierungsspur in das Speichermedium eingeschrieben wird und
- bei dem die mindestens zweite Strukturierungsspur entgegen der Schreibrichtung der vorhergehenden Strukturierungsspur eingeschrieben wird.

Als wesentlicher Vorteil ergibt sich bei diesem Verfahren, das eine größere Fläche des Speichermediums nacheinander mit einzelnen Strukturierungsspuren beschrieben wird, wobei das Schreiben mit alternierenden Schreibrichtungen möglich ist, ohne dass die Vorrichtung in eine Ausgangsstellung zurückgebracht werden muss.

Dabei kann in bevorzugter Weise das oben bereits erwähnte Kamerasystem eingesetzt werden, um die Position der ersten Strukturierungsspur zu vermessen, also den Rand der ersten Strukturierungsspur zu erfassen. Somit kann während des Schreibens der zweiten Strukturierungsspur ein kontinuierliches Nachführen der Vorrichtung erfolgen. Ebenso kann, wie oben erwähnt, auch eine Photodetektoranordnung eingesetzt werden.

In bevorzugter Weise kann der Transporttisch quer zur Schreibrichtung so bewegt werden, dass die zweite Strukturierungsspur direkt angrenzend an den Rand der ersten Strukturierungsspur geschrieben wird. Das Kamerasystem kann dabei auch genutzt werden, um ein Alignment, also eine Zuordnung zu bereits vorstrukturierten Materialien, insbesondere zu durch Druck, Prägung, Teilmetallisierungen und bereits existierenden Hologrammen entstandenen Vorstrukturen zu ermöglichen.

Zur Nachführung der Position der Belichtungszeile bzw. des Belichtungsabschnittes kann beispielsweise auch das oben erwähnte verstellbare optische Element, beispielsweise in Form des Strahlteilers oder Spiegels eingesetzt werden. Mit der Bewegung dieses optischen Elements kann insbesondere eine Bewegung quer zur Bewegungsrichtung des Transporttisches relativ zur Verkleinerungsoptik erreicht werden. Zusätzlich oder alternativ kann auch der Modulator mittels eines Piezoantriebes verschoben bzw. verstellt werden.

Ein Speichermedium kann mittels einer zuvor beschriebenen Vorrichtung mikrostrukturiert werden, mit einer optisch veränderbaren Schicht, wobei die Schicht in einem vorgegebenen Bereich mikrostrukturiert ist, wobei die Abmessung des mikrostrukturierten Bereiches zumindest in einer Richtung mindestens 10 mm beträgt. Vorzugsweise beträgt die Abmessung mindestens 50 mm. Dabei kann die Auflösung der Mikrostrukturierung im Mikrometerbereich und auch im Submikrometerbereich liegen.

Durch die Anwendung der oben beschriebenen Vorrichtung können erstmals so große Flächen mit einer derartigen Auflösung beschrieben werden, dass sich bisher nicht mögliche Anwendungen ergeben.

Beispielsweise kann der mikrostrukturierte Bereich in Form eines Streifens mit einer Länge eingeschrieben werden, die einem Mehrfachen der Breite des Streifens entspricht. Somit wird das Längeverhältnis der Seitenkanten des mikrostrukturierten Bereiches verändert, so dass beispielsweise auf einem Sicherheitsdokument ein Streifen mit einer Mehrzahl von mikrostrukturierten Informationen gespeichert werden kann, die zur Echtheitsprüfung ausgelesen und kontrolliert werden können. Dabei kann in bevorzugter Weise die Länge mindestens dem Dreifachen der Breite, vorzugsweise dem Fünffachen der Breite, insbesondere dem Zehnfachen der Breite entsprechen.

Ebenso ist es bei der angegebenen Größe der Mikrostrukturierung möglich, dass der mikrostrukturierte Bereich mindestens zwei verschiedene Informationsinhalte aufweist, wobei bevorzugt mindestens ein Informationsinhalt ein computergeneriertes Hologramm ist. Ebenso kann der Informationsinhalt ein Dotmatrixhologramm ein Mikrobild bzw. eine Mikroschrift oder eine Mikrokodierung sein.

Eine Vorrichtung zur Autofokussierung einer Abbildungsoptik einer Scheibvorrichtung zur Mikrostrukturierung eines Speichermediums weist auf:

- mindestens zwei Lichtquellen,
- mindestens einen Strahlteiler zum Leiten der von den Lichtquellen erzeugten Lichtstrahlen auf die Abbildungsoptik,
- mindestens zwei Detektoren zur Analyse der vom Speichermedium reflektierten Lichtstrahlen,
- mindestens einen Strahlteiler zum Leiten des vom Speichermedium reflektierten und durch die Abbildungsoptik verlaufenden Lichts auf die mindestens zwei Detektoren und
- eine Linse zur Fokussierung des reflektierten Lichts auf die mindestens zwei Detektoren.

Mit der Bereitstellung von mindestens zwei Abtastpunkten kann während des Schreibens einer Mikrostrukturierung, insbesondere mittels einer Belichtungszeile, für beide Bewegungsrichtungen des Schreibvorgangs der Abschnitt der Oberfläche des Speichermediums mit mindestens einem Abtastpunkt erfasst werden, der noch nicht beschrieben worden ist. Zusätzlich oder alternativ dazu können mindestens zwei Abtastpunkte verwendet werden, um neben einem Abstand auch noch eine Verkippung des Speichermediums relativ zur Abbildungsoptik festzustellen.

Weitere Ausgestaltungen und Vorteile der erfindungsgemäßen Vorrichtung sind in der speziellen Beschreibung der Ausführungsbeispiele dargestellt.

Ein Verfahren zur Autofokussierung einer Abbildungsoptik einer Schreibvorrichtung zur Mikrostrukturierung eines Speichermediums, wobei der Abstand der Abbildungsoptik relativ zum Speichermedium geregelt wird, beinhaltet ein Verfahren,

- bei dem mit mindestens zwei Lichtquellen Lichtstrahlen erzeugt und auf die Abbildungsoptik geleitet werden,
- bei dem die Lichtstrahlen auf die Oberfläche des Speichermediums in einem Abtastpunkt fokussiert und dort reflektiert werden,
- bei dem mit mindestens zwei Detektoren zur Analyse der vom Speichermedium reflektierten Lichtstrahlen Fokusfehlersignale erzeugt werden,
- bei dem mit mindestens einem Strahlteiler das vom Speichermedium reflektierte und durch die Abbildungsoptik verlaufende Licht auf die mindestens zwei Detektoren geleitet wird,
- bei dem das reflektierte Licht auf die mindestens zwei Detektoren fokussiert wird und
- bei dem in Abhängigkeit vom Fokusfehlersignal mindestens eines der Detektoren die Regelung des Abstands der Abbildungsoptik relativ zum Speichermedium durchgeführt wird.

Mit dem zuvor beschriebenen Verfahren werden die oben erläuterten Möglichkeiten mit mindestens zwei Abtastpunkten genutzt. Weitere Ausgestaltungen und Vorteile des Verfahrens sind in der speziellen Beschreibung der Ausführungsbeispiele dargestellt.

Ein Verfahren zur Autofokussierung einer Abbildungsoptik einer Schreibvorrichtung zur Mikrostrukturierung eines Speichermediums, wobei der Abstand und die Verkippung der Abbildungsoptik relativ zum Speichermedium geregelt wird, beinhaltet ein Verfahren,

- bei dem mit mindestens einer Lichtquelle ein Lichtstrahl erzeugt und auf die Abbildungsoptik geleitet wird,
- bei dem der Lichtstrahl auf die Oberfläche des Speichermediums gelenkt und dort reflektiert wird,
- bei dem in mindestens zwei Punkten der Oberfläche der Abstand zwischen der Abbildungsoptik und der Oberfläche des Speichermediums bestimmt wird und
- bei dem aus den gemessenen Abständen der Abstand und die Verkippung bestimmt und geregelt wird.

Mit dem zuvor genannten Verfahren ist es möglich, beim Schreibvorgang nicht nur den Abstand, sondern auch eine eventuelle Verkippung zwischen der Oberfläche des Speichermedium und der Abbildungsoptik bestimmen zu können, um eine aktive Regelung durchführen zu können. Weitere Ausgestaltungen und Vorteile des erfindungsgemäßen Verfahrens sind in der speziellen Beschreibung der Ausführungsbeispiele dargestellt.

Ein Verfahren zur Bestimmung des Arbeitspunktes einer Vorrichtung zur Autofokussierung einer Abbildungsoptik einer Schreibvorrichtung zur Mikrostrukturierung eines Speichermediums, wobei der Abstand und/oder die Verkippung der Abbildungsoptik relativ zum Speichermedium geregelt wird, beinhaltet ein Verfahren,

- bei dem ein vorgegebener Bereich der Oberfläche des Speichermediums mit einem vorgegebenem Muster strukturiert wird,
- bei dem entlang einer Achse die Intensität und entlang der anderen Achse die Belichtungshöhe kontinuierlich verändert wird,
- bei dem nachfolgend der belichtete Bereich mikroskopisch analysiert und der Arbeitspunkt festgelegt wird.

Mit dem zuvor beschriebenen Verfahren ist es möglich eine sehr genaue und effektive Kalibrierung der Schreibintensität und der Abstandsregelung zu verwirklichen. Weitere Ausgestaltungen und Vorteile des Verfahrens sind in der speziellen Beschreibung der Ausführungsbeispiele dargestellt.

Die zuvor beschriebenen Autofokussierungssysteme und -verfahren zur Anpassung der Entfernung des Speichermediums von der Abbildungsoptik ermöglichen eine ausreichende Nachführung des Abstandes zwischen dem Speichermedium und der Abbildungsoptik, die aufgrund der starken Fokussierung und der damit verbundenen sehr kurzen Ausdehnung des Fokus entlang der Ausbreitungsrichtung erforderlich ist.

Ein Verfahren zur Steuerung einer Vorrichtung zur Mikrostrukturierung eines Speichermediums weist die folgenden Schritte auf:

- eine Strukturierungsspur wird in einer Schreibrichtung zeilenweise in das Speichermedium eingeschrieben,
- ein Einzelpixel wird mit einer vorgegebenen Maximalintensität ausgebildet und
- mindestens zwei benachbart zu schreibende Pixel werden mit einer Intensität kleiner als die Maximalintensität ausgebildet.

Die Belichtungsstrategie ist aber nicht von der zuvor beschriebenen genauen Ausgestaltung der Vorrichtung abhängig, sondern betrifft alle Belichtungsvorgänge, bei denen zeilenweise oder flächenweise Mikrostrukturen in ein Speichermedium eingebracht werden.

Das Verfahren dient also der Korrektur von sogenannten Nachbarschaftseffekten, die während des Schreibvorgangs auftreten.

In bevorzugter Weise wird dazu Kontrollsystem zur Korrektur der Nachbarschaftseffekte während der Laufzeit zusammen mit einem Algorithmus bestehend aus einer Aufspaltung des Zeilenprofils in einen Proportionalanteil und in einen Differentialanteil angewendet. Abhängig von variabel wählbaren Parametern, die unter anderem materialspezifisch sein können, kann die Korrektionstiefe eingestellt werden.

Dabei wird eine spezielle Pulsstrategie als Freiheitsgrad bei der Materialstrukturierung eingesetzt, die vorzugsweise elektronisch einstellbar ist, insbesondere in Abhängigkeit davon, ob die Belichtungszeile orthogonal oder schräg zur Bewegungsrichtung ausgerichtet ist.

Der Strukturierungsgrad von einzelnen Belichtungspunkten in einem gerasterten Muster, also beispielsweise die Stärke der durch die Belichtung erfolgten Umwandlung der optischen Eigenschaft des Materials des Speichermediums, soll dabei unabhängig von der Strukturierung bzw. Belichtung der Umgebung sein.

Um diese Forderung zu erfüllen, kann bei der Ansteuerung der Pixel und somit bei der Wahl der Belichtungsintensität auf so genannte Nachbarschaftseffekte Rücksicht genommen werden. In der oben beschriebenen lithographischen Vorrichtung muss hier von zwei unterschiedlichen Effekten ausgegangen werden. Zum einen kommt es innerhalb einer Belichtungszeile zu Intensitätserhöhungen bei nebeneinander gesetzten Punkten im Vergleich zu einem einzelnen gesetzten Punkt, zum anderen kommt es aufgrund von Wärmeausbreitung zu unterschiedlichen Materialeigenschaften abhängig davon, ob kurz davor (Mikrosekunde) in der Nachbarschaft ein Punkt gesetzt wurde. Mit anderen Worten sollen nicht nur in Richtung der Belichtungszeile, sondern auch in Schreibrichtung Nachbarschaftseffekte berücksichtigt werden. Dieser letzte Effekt der zeitlichen Nachbarschaft ist bei geringen Schreibgeschwindigkeiten weniger dominant und kann im Allgemeinen vernachlässigt werden.

Der Effekt der unterschiedlichen Ausbildung der Speicherpunkte kann durch eine Vorprozessierung der zu schreibenden Daten kompensiert werden.

Ein Verfahren zur Steuerung einer Vorrichtung zur Mikrostrukturierung eines Speichermediums weist die folgenden Schritte auf:

- eine Strukturierungsspur wird in einer Schreibrichtung zeilenweise in das Speichermedium eingeschrieben wird und
- in jeder Belichtungsspur werden nur jeweils beabstandet zueinander angeordnete Einzelpixel mit einer vorgegebenen Maximalintensität ausgebildet.

Diese ebenfalls Belichtungsstrategie besteht also darin, separate Pixel zu schreiben, die keine direkten Nachbarn aufweisen.

Die Erfindung wird im Folgenden anhand von Ausführungsbeispielen näher erläutert, wozu auf die beigefügte Zeichnung Bezug genommen wird. In der Zeichnung zeigen

Fig. 1    eine erfindungsgemäße Vorrichtung zur Mikrostrukturierung eines Speichermediums mit den optischen Elementen zum Erzeugen eines Schreibstrahls,

Fig. 2    eine erfindungsgemäße Vorrichtung zur Mikrostrukturierung eines Speichermediums mit den optischen Elementen zum Überwachen und Steuern des Schreibvorgangs,

Fig. 3    eine schematische Darstellung des Schreibens von zwei nebeneinander liegenden Strukturierungsspuren,

Fig. 4    eine schematische Darstellung eines Belichtungskeils zur Bestimmung des Fokusfehlers und Bestimmung des Arbeitspunktes,

Fig. 5    eine schematische Darstellung zur Erläuterung einer Einpunkthöhenregelung,

Fig. 6    eine schematische Darstellung zur Erläuterung einer Zweipunkthöhenregelung,

Fig. 7 eine schematische Darstellung zur Erläuterung einer scannenden Höhenregelung,

Fig. 8 eine schematische Darstellung zur Erläuterung einer Höhenregelung auf der Basis eines Wellenfrontsensors,

Fig. 9 eine schematische Darstellung zur Erläuterung einer Höhenregelung auf der Basis eines einfachen Wellenfrontsensors,

Fig. 10 eine schematische Darstellung zur Erläuterung einer Höhenregelung auf der Basis eines positionsabhängigen Phasenverschiebung,

Fig. 11 eine schematische Darstellung zur Erläuterung einer ersten Schreibstrategie und

Fig. 12 eine schematische Darstellung zur Erläuterung einer zweiten Schreibstrategie.

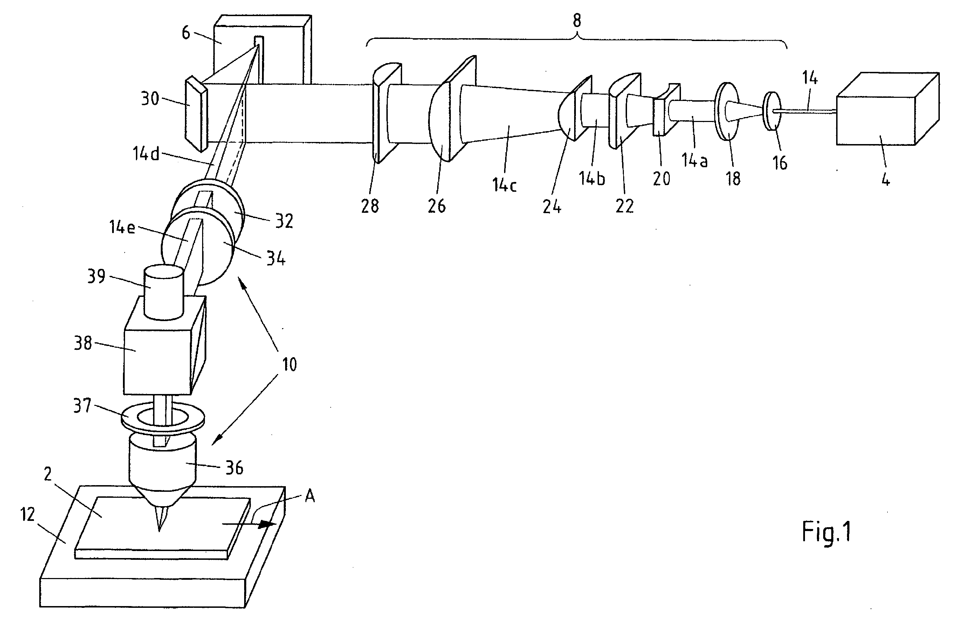

Fig. 1 zeigt den Aufbau der optischen Komponenten einer Vorrichtung zur Mikrostrukturierung eines Speichermediums 2.

Ein Laser 4 dient als Strahlungsquelle zum Erzeugen eines zumindest teilweise kohärenten Lichtstrahls 14.

Ein Lichtmodulator 6 ist in Form eines Zeilenlichtmodulators im Strahlengang angeordnet, der eine Mehrzahl von einzeln schaltbaren Modulatorelementen aufweist.

Eine Strahlformungsoptik, die insgesamt mit dem Bezugszeichen 8 gekennzeichnet ist, dient zum Ausleuchten des Modulators 6.

Eine Verkleinerungsoptik, die insgesamt mit dem Bezugszeichen 10 gekennzeichnet ist, dient zum Verkleinern der vom Modulator 6 abgestrahlten Intensitätsverteilung.

Ein Transporttisch 12 ist vorgesehen, um das Speichermedium 2 relativ zur Verkleinerungsoptik 10 zu bewegen.

Erfindungsgemäß ist die Verkleinerungsoptik 10 beugungsbegrenzt ausgebildet und die Verkleinerungsoptik 10 erzeugt ausgehend von der Fläche der einzelnen Modulatorelemente eine Flächenverkleinerung von mindestens 25, vorzugsweise von mindestens 50. Wie oben bereits beschrieben, liegt der Bereich der günstigen Verkleinerungsfaktoren im Bereich zwischen 50 und 1000, insbesondere bei 250.

Die Verkleinerungsoptik 10 verkleinert also die von jedem Modulatorelement gebeugte Strahlungsintensität auf eine Größe von weniger als 10 $\mu$m Durchmesser, insbesondere weniger als 1 $\mu$m Durchmesser. Die damit erzielbaren Strukturgrößen auf der Oberfläche des Speichermediums sind somit im Mikrometerbereich bis hin zum SubMikrometerbereich einzuordnen. Derart kleine Strukturierungen in durch die erfindungsgemäße Vorrichtung beschreibbaren Flächengrößen bis zu 1 m$^2$ führen zu einer Vielzahl neuer Anwendungen.

Der Laser 4 ist vorliegend als gepulster diodengepumpter Festkörperlaser im sichtbaren Spektralbereich ausgebildet und erzeugt einen monomoden Laserstrahl 14.

Der Modulator 6 ist ein einzeiliger, aus separat schaltbaren Modulatorelementen bestehender Lichtmodulator, der auch als Grating Light Valve (GLV) bekannt ist. Die einzelnen Modulatorelemente bestehen jeweils aus einer Mehrzahl von einzelnen Streifen, die wechselweise durch elektronische Ansteuerung aus ihrer ebenen Anordnung heraus verstellt werden können. Durch eine entsprechende Ansteuerung können die verstellbaren Streifen in der Ebene der nicht verstellbaren Streifen so angeordnet werden, dass eine spiegelnde Oberfläche entsteht. Werden die Streifen dagegen verstellt, dann entsteht ein Modulator mit einer von der spiegelnden Oberfläche abweichenden Abstrahlungscharakteristik. Dadurch lässt sich die Abstrahlcharakteristik der einzelnen Modulatorelemente gezielt verändern und somit über die Vielzahl der Modulatorelemente hinweg ein charakteristisches Zeilenmuster einstellen. Typischer Weise weist ein Grating Light Valve 1000 oder mehr Modulatorelemente auf. Die Abmessung eines solchen Zeilenlichtmodulators kann typischer Weise 30 mm x 25 $\mu$m betragen, wobei die einzelnen Modulatorelemente Abmessungen von ca. 25 $\mu$m Länge aufweisen.

Die Strahlformungsoptik 8 erzeugt aus dem runden Strahlprofil des Laserstrahls 14 mit Gauß'scher radialer Intensitätsverteilung ein auf die Fläche des einzeiligen Lichtmodulators angepasstes Strahlprofil.

Dazu weist die Strahlformungsoptik 8 zunächst zwei Linsen 16 und 18 auf, die den Laserstrahl 14 aufweiten und die im Abstand der Summe beider Brennweiten zueinander angeordnet sind. Die Brennweite der Linse 16 ist dabei kleiner als die Brennweite der Linse 18. Im Abschnitt 14a des Strahlengangs hat der Laserstrahl daher einen größeren Durchmesser als am Ausgang des Lasers 4.

Der Strahlengang weist dann zwei Zylinderlinsen 20 und 22 auf, die aus der aufgeweiteten rotationssymmetrischen Intensitätsverteilung des Laserstrahls 14 eine elliptische Intensitätsverteilung im Abschnitt 14b des Strahlengangs erzeugen.

Die Strahlformungsoptik 8 weist dann eine Powell Linse 24 auf, die aus der elliptischen Intensitätsverteilung eine annähernd rechteckförmige Intensitätsverteilung, auch als flat-top bezeichnet, erzeugt. Die Powell-Linse ist an sich aus dem Stand der Technik bekannt, wie bereits in der allgemeinen Beschreibung angegeben worden ist. Im Abschnitt 14c des Strahlengangs hat der Laserstrahl also eine im Wesentlichen gleichmäßige Intensitätsverteilung entlang der in Fig. 1 dargestellten senkrechten Richtung.

Eine Kollimationslinse 26 erzeugt aus dem die Powell Linse 24 verlassenen divergierenden Strahl ein paralleles Strahlenbündel, das durch die nachfolgende zylindrische Sammellinse 28 fokussiert wird. Ein Spiegel 30 lenkt den fokussierten Strahl auf den Zeilenlichtmodulator 6. Dabei sind die Modulatorelemente des Zeilenlichtmodulators 6 im Wesentlichen in der Brennebene der Sammellinse 28 angeordnet.

Wie bereits oben erläutert worden ist, besteht eine Anforderung an das optische System, dass jedes Modulatorelement mit einer ebenen Welle beleuchtet wird, deren Abweichung von der ebenen Welle einen maximalen Wert von λ/4 nicht überschreitet. Bevorzugt ist dabei, dass benachbarte Pixel mit Licht bestrahlt werden, deren ebene Welleneigenschaften nicht stärker als λ/4 voneinander abweichen. Besonders günstig ist es jedoch, wenn das gesamte auf die Modulatorelemente projizierte Licht als ebene Welle charakterisiert werden kann.

Daher ist die Strahlformungsoptik 8 in bevorzugter Weise insgesamt beugungsbegrenzt ausgebildet.

Die Verkleinerungsoptik 10 ist im Strahlengang hinter dem Zeilenlichtmodulator 6 angeordnet. Dazu ist zunächst eine Kollimationsoptik bestehend aus zwei Linsen 32 und 34 vorgesehen, die aus den einzelnen von den nahezu punktförmigen Modulatorelementen abgestrahlten Einzelstrahlen im Abschnitt 14d parallele Strahlen im Abschnitt 14e erzeugt. Diese parallelen Strahlen werden dann von einem Objektiv 36 auf die Oberfläche des Speichermediums 2 fokussiert. Der fokussierte Strahl kann dann auch als Schreibstrahl bezeichnet werden, weil er die zur Mikrostrukturierung erforderliche Schreibenergie in das Speichermedium 2 einbringt.

Obwohl in Fig. 1 nur ein Objektiv dargestellt ist, kann die Verkleinerungsoptik 10 mindestens zwei verschiedene Objektive mit unterschiedlichen Brennweiten und/oder numerischer Apertur aufweisen, um ein schnelles Umschalten zwischen verschieden großen Punktgrößen beim Erzeugen der Mikrostrukturierung zu erzielen. Die Objektive 36 sind bevorzugt als Mikroskopobjektive ausgebildet.

Im Strahlengang vor dem Objektiv 36 ist als weiteres strahlformendes Element eine Lochblende 37 angeordnet. Die Lochblende 37 realisiert einen Ortsfrequenzfilter. Durch die Kollimationsoptik der Linsen 32 und 34 wird das Abbild der Modulatorelemente des Modulators 6 in die Fourierebene im Bereich der Lochblende 37 fouriertransformiert. In der Fourierebene entstehende höhere Beugungsordnungen werden durch die Lochblende 34 abgeblockt, so dass weitgehend nur das Licht der nullten Beugungsordnung durch das Objektiv 36 fokussiert wird.

Ein alternativer Aufbau kann dadurch realisiert werden, dass statt der ersten Ordnung die nullte Ordnung geblockt wird und dass eine der ersten Ordnungen übertragen wird. Dadurch kann ein höherer Kontrast erreicht werden, allerdings auf Kosten der Intensität des Schreibstrahls.

Die Lochblende 37 weist bevorzugt ein rechteckförmiges Loch auf, da der vom Zeilenlichtmodulator 6 erzeugte Strahl eine im Wesentlichen rechteckige Form annimmt, insbesondere in der Fourierebene. Dagegen ist es auch möglich, eine elliptische oder runde Lochform zu nutzen.

Der unterhalb des Speichermediums 2 dargestellte Transporttisch 12 ist zweiachsig verstellbar und kann daher in einer Ebene quer zur Strahlausbreitung des fokussierten Strahls unterhalb des Mikroskopobjektivs 36 bewegt werden.

Zusätzlich kann der Transporttisch 12 das Speichermedium 2 in Richtung der Verkleinerungsoptik 10 bewegen, um eine Höhenanpassung zu ermöglichen. Dieser Freiheitsgrad ist für die Durchführung einer weiter unten erwähnten Autofokussierung vorteilhaft, um das Speichermedium möglichst genau im Fokus der Verkleinerungsoptik 10 zu halten.

Im Strahlengang zwischen den Linsen 32 und 34 der Kollimationsoptik und dem Objektiv 36 ist ein dichroitischer Strahlteiler 38 angeordnet, der mittels eines nicht dargestellten Aktuators entlang der Ausbreitungsrichtung des Strahls 14e bewegt werden kann. Durch eine Bewegung des Strahlteilers 38 kann die fokussierte Zeile von Belichtungspunkten quer zur Bewegung des Speichermediums 2, die mit dem Pfeil A dargestellt ist, verstellt und justiert werden.

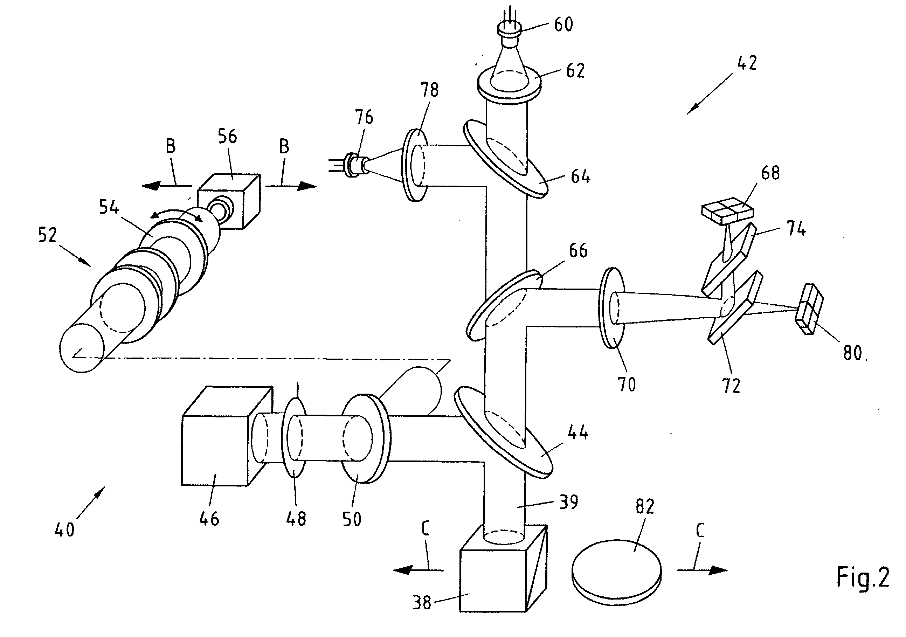

Fig. 2 zeigt den optischen Aufbau zum Überwachen und Steuern des Schreibvorgangs, insbesondere auch zum Alignment der zu belichtenden Strukturen zu bereits bestehenden Strukturen, auf dem Speichermedium 2. Dazu sind zum einen ein Kamerasystem 40, unter anderem für eine Kontrolle der Mikrostrukturierung, und zum anderen ein Autofokussierungssystem 42 vorgesehen.

Beide Systeme 40 und 42 beginnen am zuvor beschriebenen dichroitischen Strahlteiler 38. Oberhalb davon ist zunächst ein weiterer, vorzugsweise ebenfalls dichroitischer Strahlteiler 44 vorgesehen, der die beiden Strahlengänge für das Kamerasystem 40 einerseits und das Autofokussierungssystem 42 andererseits aufteilt.

Das Kamerasystem weist zunächst eine Beleuchtungsvorrichtung in Form einer Lichtquelle 46 auf, die als eine Diodenlampe (LED) oder als Halogenlampe ausgebildet ist. Eine einstellbare Blende 48 regelt die Intensität der auf die Oberfläche des Speichermediums 2 abgestrahlten Lichtmenge. Über den Strahlteiler 44 wird der Lichtstrahl nach unten in Richtung des Speichermediums 2 gerichtet, wobei der Lichtstrahl mittels des Objektivs 36 fokussiert wird. Dazu wird auf die Darstellung in Fig. 1 verwiesen, die den in Richtung des Kamerasystems 40 und des Autofokussystems 42 verlaufenden Strahl ansatzweise mit 39 zeigt.

Das von der Oberfläche des Speichermediums 2 reflektierte Licht durchläuft erneut, aber in umgekehrter Richtung das Objektiv 36, die Strahlteiler 38 und 44 und trifft auf einen, vorzugsweise 50:50 wirkenden, Strahlteiler 50. Vom Strahlteiler 50 ausgehend verläuft der Lichtstrahl (in Fig. 2 versetzt dargestellt) durch ein Objektiv 52 und einen Polarisator 54 und trifft auf eine Kamera 56.

Mit den Pfeilen B ist angedeutet, dass die Kamera 56 quer zur Ausbreitungsrichtung des Strahls bewegt werden kann. Diese Bewegungsfreiheit dient dazu, einen genügend großen Bereich der Oberfläche des Speichermediums 2 mit einer genügend großen Auflösung beobachten zu können. Wenn beispielsweise der Zeilenlichtmodulator 6 ca. 1000 Modulatorelemente aufweist und wenn die Beobachtung der abgebildeten Punkte auf der Oberfläche des Speichermediums bzw. der eingeschriebenen Mikrostruktur mit einer Auflösung von jeweils 4 Pixeln erfolgen soll, dann sind Chips mit einer Menge von 4000 Pixeln in einer Richtung erforderlich, die nur als Sonderanfertigungen erhältlich sind. Verwendet man dagegen herkömmliche Chips, dann reicht deren Menge an Pixeln nicht aus, so dass mittels der beschriebenen Bewegung quer zur Lichtausbreitung der Mangel an Auflösung kompensiert werden kann. Durch die Bewegung der Kamera 56 wird also der zu beobachtende Bereich des Speichermediums 2 gescannt.

Der zuvor beschriebene Kamerazweig 40 kann drei Aufgaben erfüllen. Der Kamerazweig 40 kann zur Voruntersuchung des zu belichtenden Speichermediums 2 verwendet werden, kann für eine mikroskopische Untersuchung des strukturierten Bereichs des Speichermediums 2 eingesetzt werden oder kann zur Kalibrierung des Modulators 6, beispielsweise also des Zeilenlichtmodulators verwendet werden.

Auf die Kalibrierung des Modulators 6 wird weiter unten im Detail eingegangen. Jedenfalls kann der vor der Kamera 56 angeordnete Polarisator 54 einer stufenlosen Intensitätsabschwächung während der Kalibrierung des Zeilenlichtmodulators dienen.

Der Kamerazweig 40 kann des Weiteren in vorteilhafter Weise für die schnelle, aber auch genaue Justierung des Gesamtsystems eingesetzt werden. Vor allem kann die Positionierung der unten beschriebenen Laserdioden bzw. Laserdioden zur Höhenregelung relativ zum Schreiblaser bzw. der Belichtungszeile verwendet werden.

Der oberhalb des Strahlteilers 44 angeordnete Zweig des optischen Aufbaus gemäß Fig. 2 stellt ein Autofokussierungssystem 42 zur Anpassung der Entfernung des Speichermediums 2 von der Verkleinerungsoptik 10 dar.

Dazu ist zunächst eine erste Laserdiode 60 vorgesehen, deren Licht mittels einer Linse 62 kollimiert wird und durch zwei vorzugsweise 50:50 Strahlteiler 64 und 66 sowie durch den dichroitischen Strahlteiler 38 und durch das Objektiv 36 auf das Speichermedium 2 gerichtet wird. Das reflektierte Licht verläuft dann in umgekehrter Richtung und ein Teil des reflektierten Lichts wird durch den Strahlteiler 66 in Richtung eines 4-Quadrantendetektors 68 geleitet, wobei im weiteren Strahlengang eine fokussierende Linse 70 und ein weiterer vorzugsweise 50:50 Strahlteiler 72 vorgesehen sind. Mittels der koplanaren Platte 74 wird ein Astigmatismus erzeugt, so dass das vom 4-Quadrantendetektor erzeugte Signal eine Richtungsinformation bezüglich der Defokussierung des Lichtstrahls auf der Oberfläche des Speichermediums aufweist.

Mittels der Defokussierungsinformation kann eine Abstandsabweichung des Speichermediums 2 von der Verkleinerungsoptik, also vom Objektiv 36 bestimmt werden und das entsprechende Signal kann zur Regelung des Abstandes, also für eine Autofokussierung benutzt werden.

Parallel zur ersten Laserdiode 60 und dem 4-Quadrantendetektor 68 sind eine zweite Laserdiode 76 mit einer weiteren Linse 78 sowie ein weiterer 4-Quadrantendetektor 80 vorgesehen. Das Licht der zweiten Laserdiode 76 wird über den Strahlteiler 64 in gleicher Weise wie das Licht der ersten Laserdiode 60 auf die Oberfläche des Speichermediums 2 gerichtet und von dort reflektiert. Das reflektierte Licht wird dann durch den Strahlteiler 72 hindurch, der dann als koplanare Platte wirkt, und mit einem Astigmatismus versehen auf den 4-Quadrantendetektor 80 gerichtet. Dort kann dann anhand der Richtungsinformation der Defokussierung ebenfalls eine Abstandsabweichung des Speichermediums 2 vom Objektiv 36 festgestellt werden.

Durch die Anwendung von zwei Laserdioden und zwei 4-Quadrantendetektoren kann sowohl zeitlich als auch räumlich unabhängig voneinander eine Autofokussierung durchgeführt werden. Dabei ergibt sich durch den beschriebenen Aufbau, dass eine maximale Anzahl von optischen Komponenten für beide Strahlengänge gemeinsam eingesetzt wird und somit ein geringer Platzbedarf entsteht.

In Fig. 2 ist am unteren Rand noch dargestellt, dass anstelle des dichroitischen Strahlteilers 38 auch ein Spiegel eingesetzt werden kann, der dann das vom Zeilenlichtmodulator 6 modulierte Licht auf das Kamerasystem 40 lenkt und somit eine direkte Beobachtung der Funktionsweise des Zeilenlichtmodulators ermöglicht. Der Strahlteiler 38 und Spiegel 82 sind entlang der mit dem Pfeil C dargestellten Richtung gemeinsam verstellbar, so dass ein Umschalten zwischen beiden Betriebsarten leicht möglich ist.

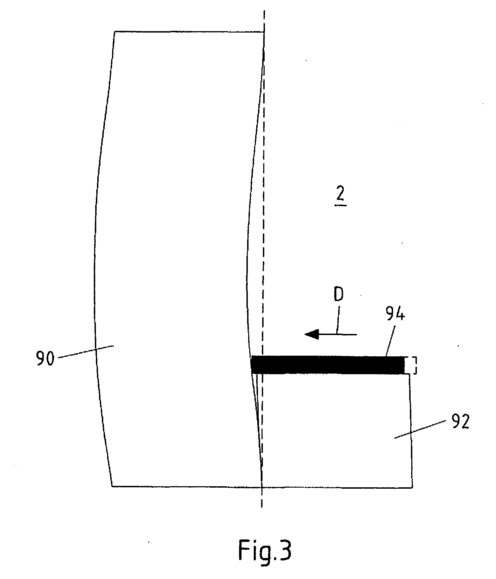

Fig. 3 zeigt eine schematische Darstellung des Beschreibens des Speichermediums 2 mit zwei nebeneinander liegenden Streifen 90 und 92 mit Mikrostrukturierungen, die beispielsweise ein zusammenhängendes computergeneriertes Hologramm bilden sollen.

Wie in Fig. 3 zu erkennen ist, weicht der Rand des Streifens 90 von der gestrichelt dargestellten geraden Linie ab, wobei die Größe der Abweichung übertrieben dargestellt ist. Der neu zu schreibende Streifen 92 soll möglichst nahe an dem ersten Streifen geschrieben werden. Dazu wird beim vorliegenden Ausführungsbeispiel mit dem Kamerasystem 40, das im Zusammenhang mit Fig. 2 beschrieben worden ist, der rechte Rand des Streifens 90 beobachtet und beispielsweise der Strahlteiler 38 so verstellt, dass die aktuell zu schreibende Zeile 94 um eine durch die Auswertung des Kamerasystems 40 ermittelte Distanz nach links entsprechend dem Pfeil D verstellt wird. Somit kann ein nahezu aneinander grenzendes Schreiben der beiden Streifen 90 und 92 realisiert werden.

Letztlich kann damit ein Schreiben einer Mehrzahl von Streifen auf einer größeren Fläche durchgeführt werden.

Im Folgenden wird das Autofokussystem 42 in seiner Funktion und Anwendung näher beschrieben, das bereits zuvor anhand der Fig. 2 erläutert worden ist.

Das Höhenregelungssystem arbeitet bevorzugt mit mehreren Abtastpunkten, insbesondere mit zwei Abtastpunkten.

Bei der Anwendung einer der oben erläuterten Vorrichtungen zur Mikrostrukturierung, deren ausgewiesenes Ziel Belichtungen von mehreren Quadratzentimetern ist, ist eine flächenhafte Höhenregelung besonders vorteilhaft. Dennoch ist die im Folgenden beschriebene Autofokussierung nicht auf die Anwendung bei einer zuvor erläuterten Vorrichtung beschränkt und kann auch bei vergleichbaren Vorrichtungen angewendet werden.

Wie bereits erwähnt worden ist, trennt ein dichroitischer Strahlteiler 38 den Belichtungszweig vom Kamerasystem 40 und vom Autofokussystem 42 des optischen Aufbaus. Siehe dazu erneut Fig. 2.

Bevorzugt ist eine Höhenregelung mit richtungsabhängigem Messpunkt. Dazu besteht der Autofokus zum Auffinden und Halten des Fokus des Schreibstrahls im Bereich der Speicherschicht des Speichermediums 2 aus einem autonomen System basierend auf dem Astigmatismusverfahren. Dabei wird eine Optik verwendet, die in zwei zueinander, meistens im rechten Winkel stehenden Richtungen quer zur Ausbreitungsrichtung des Lichtes unterschiedliche Brennweiten aufweist. Damit werden für die beiden Richtung in unterschiedlichen Entfernungen zur Optik Brennebenen erzielt, die eine Verzerrung des Strahldurchmessers in die jeweils andere Richtung bewirken. Lediglich im Bereich der halben Strecke zwischen den beiden Brennebenen ist der Strahlquerschnitt rund. Mit einem Vierquadrantendetektor kann dann festgestellt werden, wie stark und in welche Richtung der aufgenommene Strahlquerschnitt von der runden Form abweicht. Aus der Abweichung kann dann ein Rückstellsignal erzeugt werden, um eine gleichmäßige Ausleuchtung des Vierquadrantendetektors einzustellen.

Als Lichtquellen dienen die beiden in Fig. 2 dargestellten unabhängig voneinander arbeitenden Laserdioden 60 und 76, deren reflektiertes Licht von zwei Vierquadrantendetektoren 68 und 80 aufgefangen wird.

Zwei Höhenregelungssysteme sind notwendig, da sich der Detektionspunkt, abhängig von der Bewegungsrichtung des Speichermediums 2 relativ zum Schreibstrahl, entweder auf der linken oder auf der rechten Seite vom Belichtungsbereich befinden muss. Denn nur in einem nicht strukturieren, also unbelichteten Bereich des Speichermediums 2 ist eine sinnvolle Auswertung des Fokusfehlersignals möglich. Zudem soll der Autofokuspunkt vorauseilend zum Schreibvorgang bestimmt werden, um eine Änderung der Höhenposition der Oberfläche des Speichermediums 2 nachfolgend korrigieren zu können.

Für eine Einstellung der Beleuchtungspunkte der beiden Laserdioden 60 und 76 werden diese jeweils so angeordnet, dass die beiden Beleuchtungspunkte links und rechts von der Fokuslinie des fokussierten Schreibstrahls auf der Oberfläche des Speichermediums 2 angeordnet sind. Dazu sind die beiden Laserdioden 60 und 76 in ihrer Position mechanisch und/oder elektrisch einstellbar.

Die zwei unabhängigen Autofokussysteme sind überdies Platz sparend ineinander verschachtelt angeordnet und nutzen mehrere optische Komponenten gemeinsam. Vor allem die Zweige mit den Vierquadrantendetektoren 68 und 80 teilen sich die Fokuslinse 70.

Anstelle der zuvor beschriebenen beiden Laserdioden 60 und 76 können auch weitere Lichtquellen vorgesehen sein, um weitere Beleuchtungspunkte für weitere Autofokussierungssysteme zu ermöglichen. Dazu kommt dann für jede Lichtquelle auch noch jeweils ein Vierquadrantendetektor zur Messung der Abweichung des Beleuchtungspunktes von der vorgegebenen Position. Beispielsweise können jeweils zwei oder drei Beleuchtungspunkte auf jeder Seite des fokussierten Schreibstrahls auf der Oberfläche des Speichermediums 2 angeordnet sein. Das hier beschriebene Prinzip ist also nicht auf zwei Lichtquellen beschränkt.

Ist mehr als ein Beleuchtungspunkt auf einer Seite des fokussierten Schreibstrahls vorgesehen, so kann damit nicht nur eine Abweichung der Höhenposition, sondern auch eine Detektion der Materiallage, z. B. Höhe und Verkippung festgestellt werden.

Das zuvor beschriebene System mit mehreren Abtastpunkten bzw. Beleuchtungspunkten kann auch als Mehrpunkt-Astigmatismus-Höhenregelungssystem bezeichnet werden. Abhängig von der Bewegungsrichtung des Transporttisches 12 werden dann verschiedene Höhenregelungssignale ausgewertet oder das System ändert die Position des Abtaststrahls durch eine Verstellung der Position der Lichtquellen oder eines im Strahlengang angeordneten optischen Mittels wie Strahlteiler oder Spiegel.

Zur genauen Positionierung des Abstandes zwischen dem Objektiv 36 und dem Speichermedium 2 wird der Arbeitspunkt bestimmt. Die Arbeitspunktbestimmung kann, insbesondere bei Endlosbelichtungen, automatisiert werden, indem in zeitlicher und örtlicher Nähe die Beugungseffizienz einer geschriebenen Teststruktur mittels vorzugsweise eines Photodetektors oder einer Kamera bei sich verändernder Einstellung des Arbeitspunktes analysiert wird. Über den Ort bzw. Zeit kann dann auf die Arbeitspunkteinstellung geschlossen werden, bei der die beste, jedoch nicht zwingend höchste Beugungseffizienz erreicht wurde. Hier kann auch durch die Auswertung höherer Beugungsordnungen zusätzliche Informationen gewonnen werden. Weiter kann der Arbeitspunkt, vorzugsweise automatisch, durch die Auswertung einer Kontrastfunktion der belichteten Struktur erfolgen.

Wird durch das Autofokussystem mit mindestens zwei Beleuchtungspunkten, also beispielsweise mit einer Zweipunktautofokusregelung, eine Verkippung erkannt, so kann eine Verkippungskorrektur des Speichermediums während der Laufzeit mittels eines Aktuators erfolgen, der das Beugungsgitter 6 in der entsprechenden Richtung verkippt.

Der örtliche Versatz durch die prozessbedingte Verzögerung beim Schreibprozess wirkt sich vor allem beim bidirektionalen Schreiben aus. Um eine Verschlechterung der belichteten Struktur zu vermeiden, kann eine elektronische Versatzkorrektur vorgesehen sein. Im Prinzip besteht die Versatzkorrektur in einer einstellbaren zusätzlichen Verzögerungszeit und/oder einem örtlichen Vortrigger des Lasers. Dadurch wird die Zeitspanne ausgeglichen, die zwischen dem Messen der Höhenposition bzw. der Verkippung und dem Schreibzeitpunkt vergeht, in der das Speichermedium zwischen der Messposition und der Schreiposition verstellt wird. Weiter wird die Verkippung ebenfalls durch eine zusätzliche einstellbare Verzögerung realisiert - hier jedoch linear steigend, wohingegen sie bei der Versatzkompensation fix ist.

Die Höhenregelung beruht auf dem Astigmatismus-Prinzip, wie er auch in CD- oder DVD-Laufwerken eingesetzt wird. Anhand der Orientierung des durch den Astigmatismus deformierten auf einen Vierquadrantendetektor abgebildeten, rückreflektierten Strahls kann das Ausmaß und die Orientierung der Defokussierung detektiert werden. Diese Information dient dazu einen Aktuator anzusteuern, der die Probe oder das optische System entsprechend dem Höhenprofil des Speichermaterials nachfährt.

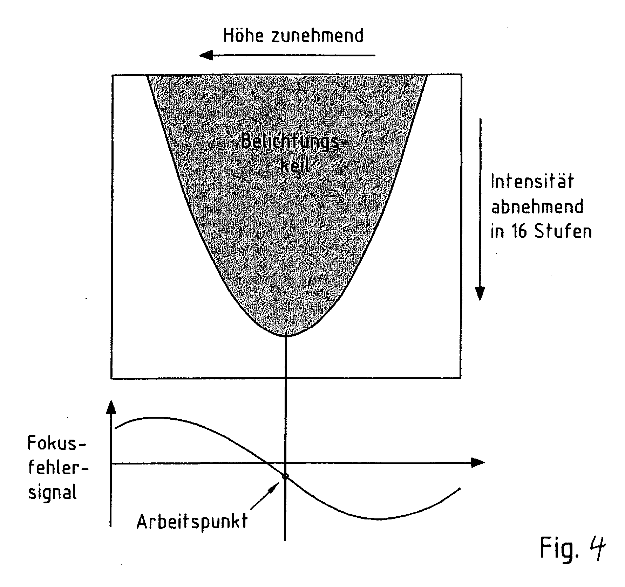

Das Verfahren zur Arbeitspunktbestimmung beruht auf der Herstellung eines Belichtungskeils. Hierzu wird auf die Fig. 4. Hierbei wird ein Bereich des Materials strukturiert in dem entlang der einen Achse die Intensität und entlang der anderen Achse die Belichtungshöhe kontinuierlich verändert wird. Für die Intensität wird vorzugsweise ein Wertebereich von 16 verschiedenen Graustufen eingesetzt. Die Höhe wird über den Bereich der S-Kurve (etwa 20 $\mu$m) variiert, der vorher bei der Justage der S-Kurve festgelegt wurde. Eine mikroskopische Analyse des belichteten Bereichs führt zu einem Keil, siehe Fig. 4. Es wird dort die optimale Belichtungshöhe angenommen, wo es bei geringster Intensität noch zur Strukturierung kommt. Da die Belichtungshöhe aufgrund der Hysterese keinen festen Bezug zur Ansteuerspannung des Aktuators besitzt, wird vorzugsweise das Fokusfehlersignal (FFS) als Referenz für eine optimale Belichtung herangezogen. Die FFS-Spannung ist somit der Arbeitspunkt der Höhenregelung.

Um den Belichtungskeil in Relation zum Fokusfehlersignal setzen zu können, ist eine schnelle Erzeugung und Speicherung der S-Kurve synchron zum Belichtungstakt notwendig. Die Belichtung des Keils sollte bei normaler Belichtungsgeschwindigkeit erfolgen, um die Aussagekraft für die spätere großflächige Belichtung zu erhöhen. Die Belichtung des Grauwertkeils und die Bestimmung des Arbeitspunktes ergeben sich wie folgt:

Zunächst wird mittels der Mikroskopiefunktion im Kamerazweig der Vorrichtung ein Bereich für den Grauwertkeil ausgewählt. Dies geschieht durch das Nullen einer Positionszählers in der Ansteuerelektronik.

Das Belichtungsmuster des Grauwertkeils (16 Grauwerte) wird geladen.

Der Transporttisch wird um eine definierte Position zurückgesetzt, um Anlauf für den Belichtungsvorgang zu nehmen.

Das Höhenregelungsmodul wird in den Modus "Grauwertkeil" versetzt. Dies bewirkt, dass getriggert vom Laserpuls die Werte der S-Kurve in einem Speicher abgelegt werden. Hierbei kann sich der Speicher entweder bevorzugt im Höhenregelungsmodul befinden oder aber auch in der Ansteuerelektronik.

Die Belichtung des Grauwertkeils erfolgt vorzugsweise über 16 Grauwert- bzw. Intensitäts- und 128 Höhenstufen, wobei die genannten Zahlenwerte beispielhaft zu verstehen sind und lediglich bevorzugt sind. Dabei wird die Ansteuerspannung des Piezoaktuators der Höhenverstellung des Mikroskopobjektives in den vorab definierten Bereichen verändert. Die Bereichseinschränkung erfolgt bei der Justage der Höhe der S-Kurve mittels Benutzereingriff. Gleichzeitig mit der Belichtung und der Änderung des Piezospannung wird der Wert der S-Kurve ermittelt und abgespeichert.

Nach der Belichtung wird der Mikroskopiemodus der Vorrichtung aktiviert. In diesem Modus wird die Spitze des Belichtungskeils durch das Verfahren des Lineartisches in die Mitte des Kamerabildes bzw. Zielmarke gebracht. Hier wird die aktuelle Position des Transporttisches aus der Ansteuerelektronik ausgelesen.

Ebenfalls ausgelesen werden die gespeicherten S-Kurvendaten. Anhand der aktuellen Position in den ausgelesenen S-Kurvendaten kann derjenige S-Kurvenwert ausgelesen werden, bei dem es zu einer optimalen Belichtung kommt. Dieser Wert ist der Arbeitspunkt der Höhenregelung.

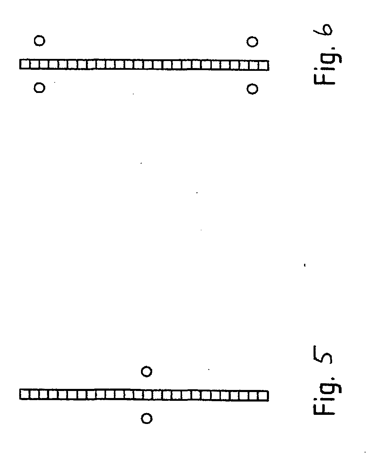

Für eine EinpunktHöhenregelung bzw. für ein bidirektionales Schreiben sind jeweils ein Beleuchtungs- bzw. Detektionspunkt auf beiden Seiten der Belichtungszeilen, also des fokussierten Schreibstrahls notwendig, da die Detektion nur im unstrukturierten Speichermedium effektiv und störungsfrei funktioniert. Diese Situation ist in Fig. 5 dargestellt, wobei die Belichtungszeile als Kästchenmuster und die beiden Beleuchtungspunkte als Kreise dargestellt sind.

Entsprechend der Bewegungsrichtung wird zur Auswertung nur einer der beiden Beleuchtungspunkte und der jeweils zugeordnete Vierquadrantendetektor herangezogen. Durch den Abstand zwischen der Belichtungszeile und dem Detektionspunkt schaut das System in die Zukunft bzw. kann das System die Reaktionszeit der Elektronik und des Aktuators kompensieren. Vorzugsweise befinden sich die Detektionspunkte in der Mitte der Belichtungszeile, jedoch kann auch jede andere Position gewählt werden, wenn dieses vorteilhaft ist.

Allerdings kann durch die in Fig. 5 gezeigte Anordnung mit jeweils einem Detektionspunkt auf jeder Seite der Beleuchtungszeile in eine Bewegungsrichtung keine Verkippung des Speichermaterials entlang der Belichtungszeile erkannt und somit kompensiert werden. Bei diesem System ist man darauf angewiesen, dass das Speichermaterial und der Fokusbereich (Tiefenschärfe) des Belichtungsstrahls parallel sind. Nur quer zur Orientierung der Belichtungszeile kann eine Höhenregelung erfolgen.

Der Aufbau der Zweipunkthöhenregelung ist in Fig. 6 dargestellt und ist ähnlich der oben beschriebenen Einpunkthöhenregelung. Um eine Verkippung zwischen der Belichtungszeile und dem Speichermedium entlang der Belichtungszeile detektieren zu können, werden statt einem Detektionspunkt bzw. Abtastpunkt zwei Detektionspunkte bzw. Abtastpunkte für jede Bewegungsrichtung verwendet. Werden die Detektionspunkte wie in Fig. 6 angeordnet, so kann eine Verkippung erkannt werden. Der Vorteil dieses Systems ist überdies, dass für jeden Detektionspunkt unabhängige Höhenregelungen eingesetzt werden können. Ein Detektionspunkt, z. B. der in Fig. 6 jeweils obere Detektionspunkt kann in einer geschlossenen Höhenregelungsschleife mit dem Piezoaktuator am Mikroskopobjektiv eingebunden werden, wobei der andere Detektionspunkt, z. B. der in Fig. 6 jeweils untere Detektionspunkt kann in einer Regelschleife mit einem Kippmechanismus, z. B. an der Befestigung des Zeilenlichtmodulators, agieren kann. Dadurch können gewöhnliche Linear-Standard-Regler, beispielsweise ein PID-Regler eingesetzt werden.

Elektronisch kann durch eine Koordinatentransformation die Kippkomponente von der z-Komponente getrennt werden und dann auf die jeweiligen Aktuatorregelkreise gegeben werden.

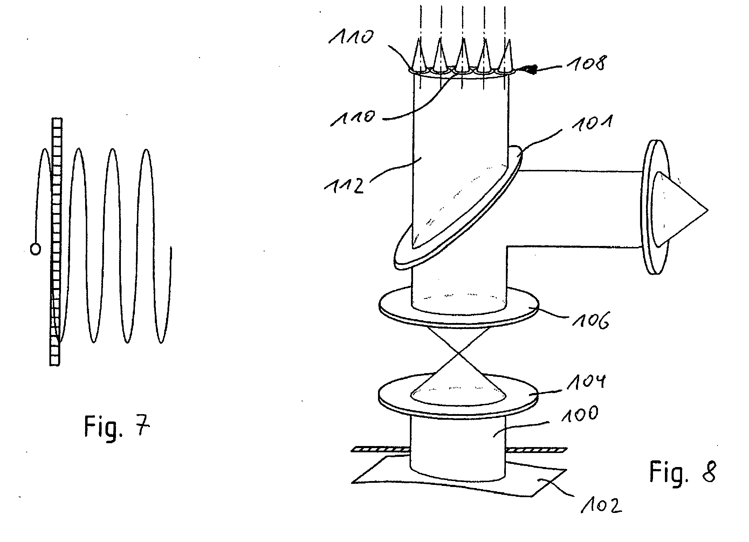

Eine weitere bevorzugte Alternative zu den vorangegangen Systemen und Methoden zur Detektion der Position der Speicherschicht mit ein oder zwei fixen Detektionspunkten ist ein System, das mit einem scannenden Detektionspunkt arbeitet und somit eine scannende Höhenregelung verwirklicht. Das Prinzip der scannenden Höhenregelung ist in Fig. 7 dargestellt.

In einem bestimmten Abstand vor der Belichtungszeile wird ein Detektionspunkt entlang der Belichtungszeile bzw. senkrecht zur Bewegungsrichtung gescannt, wodurch sich beispielsweise eine im Wesentlichen sinusförmige Wellenform ergibt. In Kombination mit der Bewegung der Belichtungszeile und des Detektionspunktes relativ zum Speichermaterial wird das Material dadurch flächenhaft belichtet und gleichzeitig abgescannt.

Der Detektionspunkt gewinnt über das oben beschriebene Astigmatismusverfahren Information über das Höhenprofil des Speichermaterials vor der Belichtungszeile. Diese Information setzt sich aus dem Errorsignal einschließlich der Spannung des Piezoaktuators des Mikroskopobjektivs zusammen. Kombiniert man die beiden Informationen mit der Ansteuerung bzw. aktuellen Position des Detektionspunktes, so erhält man ein Höhenprofil. Ziel einer Regelung ist es dann, das Integral des Fokuserrors zu minimieren, indem die Regelung zum einen den Piezoaktuator des Mikroskopobjektives anpasst und zum anderen den Aktuator für die Verkippung der Belichtungszeile relativ zum Speichermaterial verstellt.

Der Vorteil dieser Lösung liegt darin, dass ein Höhenprofil über den gesamten Schreibbereich oder zumindest einen Teil des Schreibbereichs aufgenommen werden kann. Dadurch ist eine ideale Einstellung der Höhe und Verkippung möglich. Fehler, aufgrund von Schmutzpartikeln im Detektionspunkt, können als solche erkannt und eliminiert werden. Darüber hinaus kann auf eine Verkrümmung des Speichermaterials Rücksicht genommen werden, die bei einer Zweipunktdetektion nicht erkannt wird. Überdies kann ein Höhenprofil des Speichermediums für Qualitätssicherungsaufgaben erstellt werden.

Allerdings sind die Auswertung des Höhenprofils und die Ansteuerung der Aktuatoren komplexer und benötigt infolgedessen einen höheren Rechenaufwand.

Eine weitere bevorzugte Ausgestaltung der Höhenregelung besteht in einer Wellenfronthöhenregelung, wozu zur Höhenregelung bzw. Detektion der Speicheroberfläche ein System herangezogen werden kann, dass ähnlich eines Wellenfrontsensors arbeitet, wie es in Fig. 8 dargestellt ist.

Ein kollimierter Laserstrahl 100 trifft, nach einer Umlenkung mittels eines Strahlteilers 101 auf ein Speichermedium 102. Die rückreflektierte Welle wird über einen Zwischenfokus, der durch das Linsenpaar 104 und 106 erzeugt wird, auf ein eindimensionales Linsenarry 108 gelenkt, das vorzugsweise Zylinderlinsen 110 aufweist.

Aufgrund der Fouriertransformationseigenschaft der Linsen 110 ist die Position des Fokus abhängig vom Winkel des eintreffenden Strahls 112 und somit von der Verkippung der Oberfläche des Speichermediums 102.

Die Verschiebung jedes Fokus der einzelnen Linsen 110 kann zur Detektion der Position und Orientierung der Oberfläche des Speichermediums 102 herangezogen werden. Überdies bietet diese Methode eine Möglichkeit, flächenhafte Information über die Oberfläche des Speichermediums 102 zu gewinnen.

Nimmt man statt eines eindimensionalen Linsenarrays 108 ein zweidimensionales Linsenarry mit einem zweidimensionalen Detektor, vorzugsweise einem Kamerachip, so kann man die Aktuatoren für Höhe und Verkippung des Speichermediums relativ zum Objektiv, beispielsweise des Objektivs 36 in Fig. 1, vorausschauend ansteuern.

Allerdings benötigt diese Art der Höhenvermessung eine zusätzliche absolute Höhenmessung in mindestens einem Punkt, da das oben beschriebene System nur Gradienten der Höhe und keine Absolutwerte gewinnt.

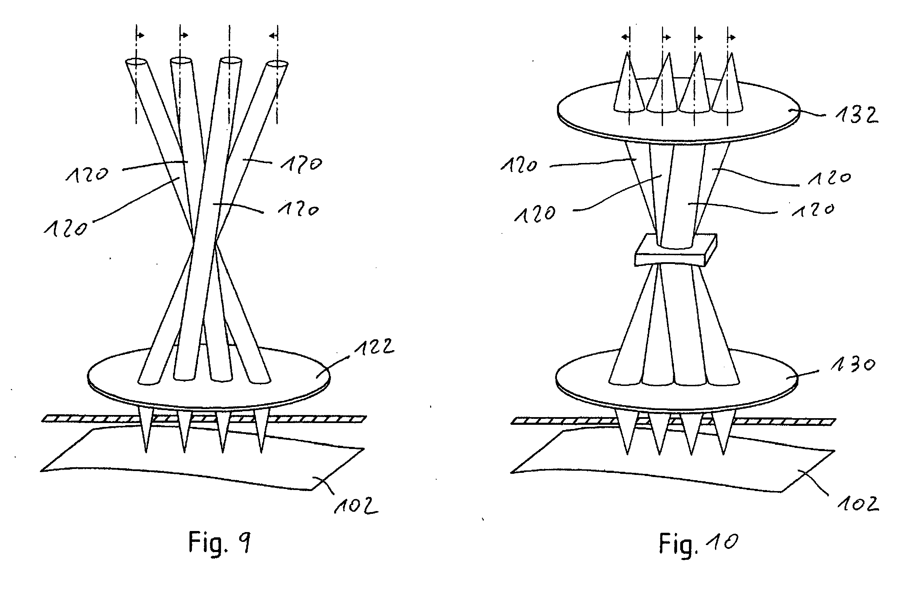

Bei einer weiteren bevorzugten Alternative kann ein einfacher Wellenfrontsensor mit dem in Fig. 9 gezeigten Aufbau realisiert werden. Dabei werden mehrere Probestrahlen 120 unter verschiedenen Winkeln auf das schematisch dargestellte Mikroskopobjektiv 122, das beispielsweise dem Objektiv 36 in Fig. 1 entsprechen kann, und das Speichermedium 102 gelenkt.

Durch eine Verkippung bzw. Deformation des Speichermediums 102 erfährt jeder Probestrahl 120 einen eigenen Versatz, der jeweils mit kleinen Pfeilen in Fig. 9 oben dargestellt ist. Ein flächenhafter Sensor (KameraChip) kann mittels Schwerpunktsberechnung der gemessenen Intensitätsverteilung den Versatz bezüglich einer Referenzposition bestimmen, aus dem wiederum auf den Gradienten der Oberfläche des Speichermediums 102 geschlossen werden kann. Auch hier ist wiederum eine absolute Höhenbestimmung an einem Punkt notwendig.

Ein weiteres bevorzugtes Ausführungsbeispiel gewinnt die Höheninformation durch einen positionsabhängigen Phasenshift. Dieses System ist schematisch in Fig. 10 dargestellt und arbeitet ebenfalls wie zuvor mit mehreren Probestrahlen 120. Durch eine Deformation der Reflexionsebene, also der Oberfläche des Speichermediums 102 wird eine Translation in der Fourierebene erzeugt. Die Fouriertransformation wird dabei durch zwei fokussierende Linsen 130 und 132 erzeugt. Bringt man in der Fourierebene zwischen den beiden Linsen ein optisches Element 134 ein, das die Phase in Abhängigkeit der Position verändert, beispielsweise eine sphärische aber auch asphärische Linse oder eine Zylinderlinse, so ergibt sich eine Verschiebung der Fokii in der Brennebene der zweiten Linse 132. Über die Verschiebung der Fokii kann dann wiederum auf die Deformation der Oberflächen des Speichermediums 102 geschlossen werden. Wie bei den zuvor beschriebenen Systemen ist auch hier eine Absolutmessung der Höhen an einem Punkt notwendig.

Eine Vielzahl von möglichen und unvermeidbaren Unzulänglichkeiten im optischen, mechanischen und elektrischen Aufbau lassen sich durch eine Kalibrierung des Modulators 6 kompensieren. Im Folgenden wird immer der bevorzugte Zeilenlichtmodulator 6 genannt, ohne dabei einen zweidimensionalen Modulator ausschließen zu wollen.

Dabei wird jeder einzelne Pixel vermessen. Das Messergebnis wird für jeden Pixel separat in einer Tabelle in einem Rechner niedergelegt. Aus dieser Tabelle wird eine Look-Up-Tabelle berechnet, die in der Ansteuerelektronik des Zeilenlichtmodulators 6 hinterlegt wird. Das zentrale Element ist eine CMOS-Kamera oder ein anderes geeignete Komerasystem, das zur lokalen Intensitätsmessung verwendet wird. Durch eine vorgelagerte Bildverarbeitung wird ein Bereich um den Fokus eines abgebildeten Pixels des Zeilenlichtmodulators identifiziert, der anschließend zur Intensitätsbestimmung herangezogen wird. Dadurch wird gewährleistet, dass bei der Messung keine Artefakte wie Lichtreflexe berücksichtigt werden. Überdies entfällt eine Feinjustage einer Photodiode, die üblicherweise für solche Messungen herangezogen wird.

Des Weiteren erlaubt die Verwendung einer CMOS-Kamera die Positionsdetektion des aktuellen Fokus. Wandert dieser aus einem zentralen Bereich heraus, dann kann mittels des Transporttisches eine gerichtete Repositionierung erfolgen.

Eine weitere Methode zur Bestimmung der Intensität eines Einzelpixels des Zeilenlichtmodulators basiert auf der Verwendung einer kleinen Apertur, vorzugsweise mit ca. 10 μm Durchmesser, unter der ein Photodetektor platziert ist und einer X-Y-Positioniervorrichtung. Mittels der X-Y-Positioniervorrichtung in der Schreibebene (Ebene des Speichermaterials) wird das Pinhole, also die kleine Apertur, zentrisch zu einem zu untersuchenden Schreibpunkt platziert. Mittels der Photodiode und einer, vorzugsweise logarithmisch arbeitenden Auswerteelektronik wird die Intensität des auftreffenden Schreibstrahls gemessen.

Die zuvor angegebene Kalibrierung erfolgt relativ aufwändig und kompensiert Ungenauigkeiten und zeitliche Schwankungen bei der Ausleuchtung des Zeilenlichtmodulators 6.

Die folgenden Funktionen sind bei der Kalibrierung gegeben:

- Submikrometervermessung des Schreibfokus
- Korrelation auf ein Pixel des Zeilenlichtmodulators
- Vermessung der Übertragungsfunktion
- Ableitung einheitlicher Intensitätsstufen über alle Pixel
- Speicherung in einer Look-Up-Table
- Korrektur der Ansteuerung des Zeilenlichtmodulators während der Laufzeit
- On-line Kontrolle und Kalibrierung der Korrektur des Zeilenlichtmodulators bzw. Ausleuchtungsoptik
- Rückkopplung der Belichtungsqualität (holographische- und musterbasierte Qualität)und on-line Kalibrierung der Belichtung

Im Scanbetrieb geht man im Zusammenhang mit dem in Fig. 1 beschriebenen Aufbau und des damit erreichten Schreibpfades davon aus, dass die Belichtungszeile relativ zum Objektiv bzw. zur Vorrichtung, insbesondere zum Objektiv 36 fix ist. Über das Einbringen eines Aktuators z. B. zur Bewegung des Strahlteilers 38 "dichroitic beam splitter" kann die Belichtungszeile relativ zum Objektiv 36 bewegt werden.

Wird eine Bewegung der Belichtungszeile in Richtung des Materialtransportes realisiert, kann dadurch ein Jitter, der unter anderem durch eine Geschwindigkeitsschwankung des Transporttisches 12 hervorgerufen wird, kompensiert werden.

Wird eine Bewegung quer zum Materialtransport realisiert, erlaubt dieser Freiheitsgrad Fehler oder Ungenauigkeiten bei der Materialführung zu kompensieren. Unter anderem ist bei einer flächenhaften Belichtung, die sich aus mehreren Belichtungszeilen zusammensetzt, ein gesteuertes Aneinandersetzen der Belichtungszeilen notwendig, siehe dazu die oben angeführte Beschreibung der Fig. 3. Durch eine Erkennung der vorangegangen Belichtung kann durch die Scannvorrichtung ein exaktes Aneinandersetzen der Spuren realisiert werden.

Ebenfalls mittels einer Bewegung der Belichtungszeile quer zur Bewegungsrichtung des Speichermediums 2 kann die Belichtung an eine im Material des Speichermediums 2 vordefinierte Position erfolgen. Dies setzt wiederum eine Detektion der vordefinierten Position, beispielsweise mittels einer geprägten Spur, voraus.

Im Folgenden werden bevorzugte Schreibstrategien bzw. Belichtungsstrategien bei der Anwendung einer Vorrichtung zur Mikrostrukturierung im Detail erläutert, die eine Steuerung der Intensität während des Schreibvorgangs betreffen. Die Belichtungsstrategie ist aber nicht von der zuvor beschriebenen genauen Ausgestaltung der Vorrichtung abhängig, sondern betrifft alle Belichtungsvorgänge, bei denen zeilenweise oder flächenweise Mikrostrukturen in ein Speichermedium eingebracht werden.

In bevorzugter Weise wird dazu ein Kontrollsystem zur Korrektur von Nachbarschaftseffekten während der Laufzeit zusammen mit einem Algorithmus bestehend aus einer Aufspaltung des Zeilenprofils in einen Proportionalanteil und in einen Differentialanteil angewendet. Abhängig von variabel wählbaren Parametern, die unter anderem materialspezifisch sein können, kann die Korrektionstiefe eingestellt werden.

Dabei wird eine spezielle Pulsstrategie als Freiheitsgrad bei der Materialstrukturierung eingesetzt, die vorzugsweise elektronisch einstellbar ist, insbesondere in Abhängigkeit davon, ob die Belichtungszeile orthogonal oder schräg zur Bewegungsrichtung ausgerichtet ist.

Der Strukturierungsgrad von einzelnen Belichtungspunkten in einem gerasterten Muster, also beispielsweise die Stärke der durch die Belichtung erfolgten Umwandlung der optischen Eigenschaft des Materials des Speichermediums, soll dabei unabhängig von der Strukturierung bzw. Belichtung der Umgebung sein.

Um diese Forderung zu erfüllen, kann bei der Ansteuerung der Pixel und somit bei der Wahl der Belichtungsintensität auf so genannte Nachbarschaftseffekte Rücksicht genommen werden. In der oben beschriebenen lithographischen Vorrichtung muss hier von zwei unterschiedlichen Effekten ausgegangen werden. Zum einen kommt es innerhalb einer Belichtungszeile zu Intensitätserhöhungen bei nebeneinander gesetzten Punkten im Vergleich zu einem einzelnen gesetzten Punkt, zum anderen kommt es aufgrund von Wärmeausbreitung zu unterschiedlichen Materialeigenschaften abhängig davon, ob kurz davor (Mikrosekunde) in der Nachbarschaft ein Punkt gesetzt wurde. Mit anderen Worten sollen nicht nur in Richtung der Belichtungszeile, sondern auch in Schreibrichtung Nachbarschaftseffekte berücksichtigt werden. Dieser letzte Effekt der zeitlichen Nachbarschaft ist bei geringen Schreibgeschwindigkeiten weniger dominant und kann im Allgemeinen vernachlässigt werden.

Der Effekt der unterschiedlichen Ausbildung der Speicherpunkte kann durch eine Vorprozessierung der zu schreibenden Daten kompensiert werden.

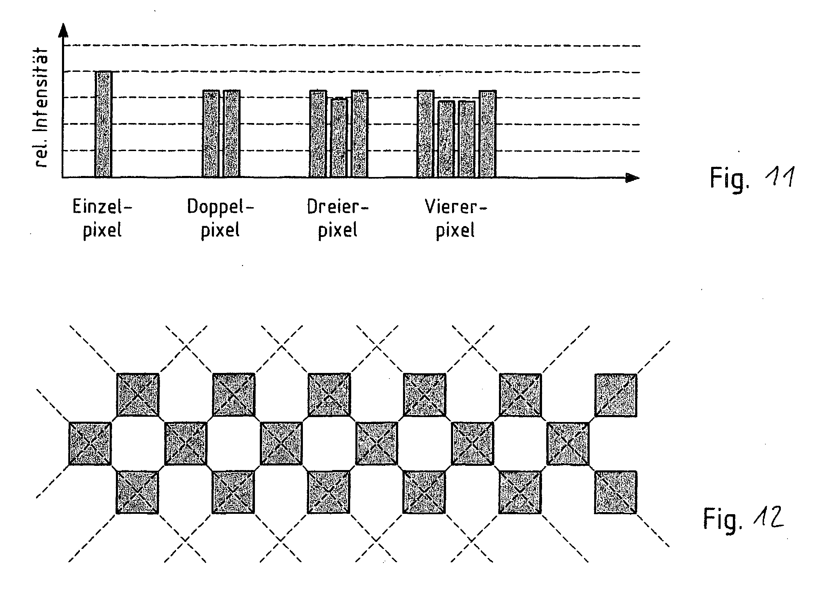

In Fig. 11 ist ein Beispiel einer Belichtungsstrategie dargestellt, der einer Vorprozessierung zu Grunde liegt. Dem Einzelpixel wird die maximale Energie zur Ausbildung zugeschrieben. Durch die Grauwertoption der Ansteuerung wird bei einem Doppelpixel die Intensität beider benachbarter Pixel reduziert. Bei drei benachbarten Pixeln wird beim mittleren Pixel die Intensität weiter reduziert. Bei weiteren benachbarten Belichtungspunkten werden die mittleren Punkte mit identischer Intensität belichtet.

Dadurch prägen sich Belichtungspunkte weitgehend identisch aus. Unter Umständen kann auf die dritte Intensitätsreduktion verzichtet werden. Die beschriebene Schreibstrategie kann sowohl innerhalb einer Belichtungszeile als auch von Belichtungszeile zu Belichtungszeile angewendet werden. Dabei kann weiterhin berücksichtigt werden, dass die einzelnen Pixel in einer Belichtungszeile gleichzeitig eingeschrieben werden und dass benachbarte Pixel aus unterschiedlichen Belichtungszeilen zeitlich versetzt eingeschrieben werden. Abhängig von den Materialeigenschaften kann allerdings eine Belichtungsstrategie von Zeile zu Zeile entfallen.

Eine weitere bevorzugte Belichtungsstrategie besteht darin, separate Pixel zu schreiben, die keine direkten Nachbarn aufweisen. Dazu wird in vorzugsweise ein Belichtungsmuster mit isolierten Belichtungspunkten eingeschrieben, wobei jeweils ein Pixel eines Paares von möglichen Belichtungspunkten bei einer gewünschten Belichtung aktiviert wird, während der andere Pixel dunkel geschaltet bleibt. Dadurch wird gewährleistet, dass jeder Pixel von einem nicht belichteten Bereich umgeben ist.

Um den dadurch größer werdenden Rasterabstand zu kompensieren kann eine doppelte Verkleinerung durch das Tauschen des Objektivs erreicht werden.

Computergenerierte Hologramme, die nach dieser Methode belichtet werden, zeigen einen geringeren Randwertabfall in der Rekonstruktion. Denn je kleiner die eingeschriebenen Punkte im Verhältnis zur gesamten Struktur sind, desto größer ist in der Rekonstruktion des Hologramms der Bereich mit ausreichend großer Intensität. Der zum Rand hin in der Intensität abfallende Bereich liegt weiter außen und führt somit zur Verbesserung der Qualität des Hologramms.

Einen nur um den Faktor $\sqrt{2}$ größeren Rasterabstand erhält man, wenn die Orientierung des Zeilenlichtmodulators zur Bewegungsrichtung gekippt wird. Dies wird erreicht, indem man den aktiven Pixel einer Paarung von Zeile zu Zeile wechselt, siehe dazu die Fig. 12.

**Patentansprüche**

1. Vorrichtung zur Mikrostrukturierung eines Speichermediums (2),

   - mit einer Strahlungsquelle (4) zum Erzeugen eines zumindest teilweise kohärenten Strahls aus elektromagnetischer Strahlung,
   - mit einem Modulator (6) mit einer Mehrzahl von einzeln schaltbaren Modulatorelementen,
   - mit einer Strahlformungsoptik (8) zum Ausleuchten des Modulators (6),
   - mit einer Verkleinerungsoptik (10) zum Verkleinern des vom Modulator (6) abgestrahlten Strahls
   - mit einer Anordnung zur Umwandlung der Phasenmodulation in eine Intensitätsmodulation (z.B. Ortsfrequenzfilter) und
   - mit einer Transportvorrichtung zum Bewegen des Speichermediums (2) relativ zur Verkleinerungsoptik (10),
   - wobei die Verkleinerungsoptik (10) ausgehend von der Fläche der einzelnen Modulatorelemente eine Flächenverkleinerung von mindestens 25 erzeugt,
   - wobei die Transportvorrichtung als Transporttisch (12) ausgebildet ist
   - wobei eine den Laser (4), den Modulator (6) und den Transporttisch (12) synchronisierende Steuerung vorgesehen ist,
   **dadurch gekennzeichnet,**
   - **dass** die Verkleinerungsoptik (10) beugungsbegrenzt ausgebildet ist,
   - **dass** Mittel zum Erzeugen eines Mastertriggers $T_0$ um eine vorgegebene Zeitdauer $\Delta T$ vor dem Erreichen der Position einer neuen in dem Speichermedium zu schreibenden Strukturierung während der Bewegung des Transporttisches vorgesehen sind,
   - **dass** Mittel zum Ansteuern der Strahlungsquelle zum Erzeugen eines Strahlungsimpulses im Zeitpunkt $T_0 + \Delta T$ vorgesehen sind,
   - **dass** Mittel zum Einstellen des Modulators vor Erreichen des Zeitpunktes $T_0 + \Delta T$ entsprechend der zu schreibenden Informationen vorgesehen sind und
   - **dass** Mittel zum Erzeugen eines Strahlungsimpuls durch die Strahlungsquelle im Zeitpunkt $T_0 + \Delta T$ vorgesehen sind.

2. Vorrichtung nach Anspruch 1,
   **dadurch gekennzeichnet,**
   **dass** die Flächenverkleinerung der Verkleinerungsoptik zwischen 25 und 1000, vorzugsweise zwischen 50 und 1000, insbesondere 250, beträgt und/oder dass die Verkleinerungsoptik (10) die von jedem Modulatorelement gebeugte Strahlungsintensität auf eine Größe von weniger als 10 μm Durchmesser, insbesondere weniger als 1 μm Durchmesser, verkleinert.

3. Vorrichtung nach Anspruch 1 oder 2,
   **dadurch gekennzeichnet,**
   **dass** die Strahlungsquelle (4) als Laser, insbesondere als gepulster Laser, ausgebildet ist, weiter vorzugsweise einen monomoden Laserstrahl oder einen multimoden Laserstrahl mit partieller Kohärenz erzeugt.

4. Vorrichtung nach einem der Ansprüche 1 bis 3,
   **dadurch gekennzeichnet,**
   **dass** der Modulator (6) ein einzeiliger, aus separat schaltbaren Modulatorelementen bestehender Lichtmodulator ist oder
   **dass** der Modulator ein zweidimensionaler, aus separat schaltbaren Modulatorelementen bestehender Lichtmodulator ist.

5. Vorrichtung nach einem der Ansprüche 1 bis 4,
   **dadurch gekennzeichnet,**
   **dass** die Strahlformungsoptik (8) beugungsbegrenzt ausgebildet ist und/oder
   **dass** die Strahlformungsoptik (8) aus dem von der Strahlungsquelle (4) erzeugten Strahlprofil ein auf die Fläche des Modulators (6) angepasstes Strahlprofil erzeugt, wobei vorzugsweise die Strahlformungsoptik (8) eine Powell Linse (24) aufweist.

6. Vorrichtung nach einem der Ansprüche 1 bis 5,
   **dadurch gekennzeichnet,**
   **dass** die Verkleinerungsoptik (10) ein Mikroskopobjektiv (36) aufweist und/oder dass die Verkleinerungsoptik (10) mindestens zwei Objektive mit unterschiedlicher Brennweite und/oder numerischer Apertur aufweist und/oder dass die Verkleinerungsoptik (10) Ortsfrequenzfilter in oder nahe der Fourierebene (37) aufweist.

7. Vorrichtung nach einem der Ansprüche 1 bis 6,
   **dadurch gekennzeichnet,**
   **dass** der Transporttisch (12) einachsig, insbesondere zweiachsig, verstellbar ist und/oder dass der Transporttisch (12) das Speichermedium (2) in Richtung der Verkleinerungsoptik (10) bewegt.

8. Vorrichtung nach einem der Ansprüche 1 bis 7,
   **dadurch gekennzeichnet,**
   **dass** ein bewegbares optisches Element (38) im Strahlengang vor der Verkleinerungsoptik zum Verschieben des verkleinerten Intensitätsmusters auf dem Speichermedium vorgesehen ist und/oder dass ein Kamerasystem (40) zur Kontrolle der Mikrostrukturierung oder zur Kontrolle einer vorgegebenen Ausrichtung oder eines Alignments relativ zu einer vorgegebenen oder bereits geschriebenen Mikrostrukturierung oder Markierung vorgesehen ist und/ oder

**dass** ein Autofokussierungssystem (42) zur Anpassung der Entfernung des Speichermediums (2) von der Verkleinerungsoptik (10) vorgehen ist.

9. Verfahren zur Steuerung einer Vorrichtung zur Mikrostrukturierung eines Speichermediums nach einem der Ansprüche 1 bis 8,

- bei dem während der Bewegung des Transporttisches ein Mastertrigger $T_0$ um eine vorgegebene Zeitdauer $\Delta T$ vor dem Erreichen der Position einer neuen in dem Speichermedium zu schreibenden Strukturierung erzeugt wird,
- bei dem die Strahlungsquelle angesteuert wird, um im Zeitpunkt $T_0 + \Delta T$ einen Strahlungsimpuls zu erzeugen,
- bei dem der Modulator vor Erreichen des Zeitpunktes $T_0 + \Delta T$ entsprechend der zu schreibenden Informationen eingestellt wird und
- bei dem die Strahlungsquelle im Zeitpunkt $T_0 + \Delta T$ einen Strahlungsimpuls erzeugt, dessen Intensitätsverteilung entsprechend der Einstellung des Modulators variiert wird.

10. Verfahren nach Anspruch 9, bei dem der Transporttisch kontinuierlich bewegt wird und bei dem die Mastertrigger $T_0$ durch die Bewegung des Transporttisches um jeweils einen vorgegebenen Abstand erzeugt werden.

11. Verfahren zur Steuerung einer Vorrichtung zur Mikrostrukturierung eines Speichermediums nach einem der Ansprüche 1 bis 8,

- bei dem eine erste Strukturierungsspur in einer Schreibrichtung in das Speichermedium eingeschrieben wird,
- bei dem mindestens eine zweite Strukturierungsspur parallel zur vorhergehenden Strukturierungsspur in das Speichermedium eingeschrieben wird und
- bei dem die mindestens zweite Strukturierungsspur entgegen der Schreibrichtung der vorhergehenden Strukturierungsspur eingeschrieben wird.

12. Verfahren nach Anspruch 11,

- bei dem der Rand der ersten Strukturierungsspur mit Hilfe einer Detektionseinrichtung, insbesondere eines Kamerasystems, erfasst wird und
- bei dem der Transporttisch quer zur Schreibrichtung so bewegt wird, dass die zweite Strukturierungsspur direkt angrenzend an den Rand der ersten Strukturierungsspur geschrieben wird.

**Claims**

1. Device for microstructuring a storage medium (2),

- comprising a radiation source (4) for generating an at least partly coherent beam of electromagnetic radiation,
- comprising a modulator (6) having a plurality of individually switchable modulator elements,
- comprising a beam shaping optical unit (8) for illuminating the modulator (6),
- comprising a reducing optical unit (10) for reducing the beam emitted by the modulator (6),
- comprising an arrangement for converting the phase modulation into an intensity modulation (e.g. spatial frequency filter), and
- comprising a transport device for moving the storage medium (2) relative to the reducing optical unit (10),
- wherein the reducing optical unit (10) produces an area reduction of at least 25 proceeding from the area of the individual modulator elements,
- wherein the transport device is formed as a transport table (12),
- wherein a controller is provided which synchronizes the laser (4), the modulator (6) and the transport table (12), **characterized**
- **in that** the reducing optical unit (10) is formed in diffraction-limited fashion,
- **in that** provision is made of means for generating a master trigger $T_0$ a predetermined time duration $\Delta T$ before the position of a new structuring to be written in the storage medium is reached during the movement of the transport table,
- **in that** provision is made of means for driving the radiation source in order to generate a radiation pulse at the instant $T_0 + \Delta T$,
- **in that** provision is made of means for setting the modulator in accordance with the information to be written, before the instant $T_0 + \Delta T$ is reached, and
- **in that** provision is made of means for generating a radiation pulse by the radiation source at the instant $T_0 + \Delta T$.

2. Device according to Claim 1, **characterized in that** the area reduction of the reducing optical unit is between 25 and 1000, preferably between 50 and 1000, in particular 250 and/or in that the reducing optical unit (10) reduces the radiation intensity diffracted by each modulator element to a size of less than 10 $\mu$m diameter, in particular less than 1 $\mu$m diameter.

**3.** Device according to Claim 1 or 2,
**characterized**
**in that** the radiation source (4) is formed as a laser, in particular as a pulsed laser, furthermore preferably generates a monomode laser beam or a multimode laser beam having partial coherence.

**4.** Device according to any of Claims 1 to 3,
**characterized**
**in that** the modulator (6) is a single-line light modulator comprising separately switchable modulator elements or in that the modulator is a two-dimensional light modulator comprising separately switchable modulator elements.

**5.** Device according to any of Claims 1 to 4,
**characterized**
**in that** the beam shaping optical unit (8) is formed in diffraction-limited fashion and/or in that the beam shaping optical unit (8) generates a beam profile adapted to the area of the modulator (6) from the beam profile generated by the radiation source (4), wherein preferably the beam shaping optical unit (8) has a Powell lens (24).

**6.** Device according to any of Claims 1 to 5,
**characterized**
**in that** the reducing optical unit (10) has a microscope objective (36) and/or in that the reducing optical unit (10) has at least two objectives having a different focal length and/or numerical aperture and/or in that the reducing optical unit (10) has spatial frequency filter in or near the Fourier plane (37).

**7.** Device according to any of Claims 1 to 6,
**characterized**
**in that** the transport table (12) is adjustable in one axis, in particular in two axes, and/or in that the transport table (12) moves the storage medium (2) in the direction of the reducing optical unit (10).

**8.** Device according to any of Claims 1 to 7,
**characterized**
**in that** a movable optical element (38) is provided in the beam path upstream of the reducing optical unit for the purpose of shifting the reduced intensity pattern on the storage medium and/or in that provision is made of a camera system (40) for monitoring the microstructuring or for monitoring a predetermined orientation or an alignment relative to a predetermined or already written microstructuring or marking and/or in that provision is made of an autofocusing system (42) for adapting the distance of the storage medium (2) from the reducing optical unit (10).

**9.** Method for controlling a device for microstructuring a storage medium according to any of Claims 1 to 8,

- in which, during the movement of the transport table, a master trigger $T_0$ is generated a predetermined time duration $\Delta T$ before the position of a new structuring to be written in the storage medium is reached,
- in which the radiation source is driven in order to generate a radiation pulse at the instant $T_0 + \Delta T$,
- in which the modulator is set in accordance with the information to be written, before the instant $T_0 + \Delta T$ is reached, and
- in which the radiation source generates, at the instant $T_0 + \Delta T$, a radiation pulse whose intensity distribution is varied in accordance with the setting of the modulator.

**10.** Method according to Claim 9,
in which the transport table is moved continuously, and in which the master triggers $T_0$ are generated by the movement of the transport table by a predetermined distance in each case.

**11.** Method for controlling a device for microstructuring a storage medium according to any of Claims 1 to 8,

- in which a first structuring track is written to the storage medium in a writing direction,
- in which at least a second structuring track is written to the storage medium in a manner parallel to the preceding structuring track, and
- in which the at least second structuring track is written counter to the writing direction of the preceding structuring track.

**12.** Method according to Claim 11,

- in which the edge of the first structuring track is detected with the aid of a detection device, in particular a camera system, and
- in which the transport table is moved transversely with respect to the writing direction such that the second structuring track is written in a manner directly adjoining the edge of the first structuring track.

**Revendications**

**1.** Dispositif de microstructuration d'un support d'enregistrement (2),

- comprenant une source de rayonnement (4) pour générer un rayon au moins partiellement cohérent constitué d'un rayonnement électromagnétique,
- comprenant un modulateur (6) avec une pluralité d'éléments modulateurs commutables individuellement,

- comprenant une optique de mise en forme du rayon (8) pour éclairer le modulateur (6),
- comprenant une optique de réduction (10) pour réduire le rayon émis par le modulateur (6),
- comprenant un arrangement pour convertir la modulation de phase en une modulation d'intensité (par exemple un filtre de fréquence de lieu) et
- comprenant un dispositif de transport pour déplacer le support d'enregistrement (2) par rapport à l'optique de réduction (10),
- l'optique de réduction (10) produisant une réduction de surface d'au moins 25 en partant de la surface des éléments modulateurs individuels,
- le dispositif de transport étant réalisé sous la forme d'un plateau de transport (12),
- une commande qui synchronise le laser (4), le modulateur (6) et le plateau de transport (12) étant prévue,

**caractérisé en ce**

- **que** l'optique de réduction (10) est réalisée avec une diffraction limitée,
- **que** sont prévus des moyens pour générer un déclencheur principal $T_0$ à une durée $\Delta T$ prédéfinie avant d'atteindre la position d'une nouvelle structuration à écrire dans le support d'enregistrement pendant le mouvement du plateau de transport,
- **que** sont prévus des moyens pour commander la source de rayonnement pour générer une impulsion de rayonnement à l'instant $T_0 + \Delta T$,
- **que** sont prévus des moyens pour régler le modulateur avant d'atteindre l'instant $T_0 + \Delta T$ conformément aux informations à écrire et
- **que** sont prévus des moyens pour générer une impulsion de rayonnement avec la source de rayonnement à l'instant $T_0 + \Delta T$.

2. Dispositif selon la revendication 1, **caractérisé en ce**
   **que** la réduction de surface de l'optique de réduction est comprise entre 25 et 1000, de préférence entre 50 et 1000, notamment vaut 250 et/ou
   **que** l'optique de réduction (10) réduit l'intensité du rayonnement diffracté par chaque élément modulateur à une taille inférieure à 10 $\mu$m de diamètre, notamment inférieure à 1 $\mu$m de diamètre.

3. Dispositif selon la revendication 1 ou 2, **caractérisé en ce que** la source de rayonnement (4) est réalisée sous la forme d'un laser, notamment sous la forme d'un laser pulsé, générant en outre de préférence un rayon laser monomodal ou un rayon laser multimodal avec une cohérence partielle.

4. Dispositif selon l'une des revendications 1 à 3, **caractérisé en ce**

**que** le modulateur (6) est un modulateur de lumière à rangée unique, constitué d'éléments modulateurs commutables séparément ou
**que** le modulateur est un modulateur de lumière bidimensionnel, constitué d'éléments modulateurs commutables séparément.

5. Dispositif selon l'une des revendications 1 à 4, **caractérisé en ce**
   **que** l'optique de mise en forme du rayon (8) est réalisée avec une diffraction limitée et/ou que l'optique de mise en forme du rayon (8) génère à partir du profil de rayon généré par la source de rayonnement (4) un profil de rayon adapté à la surface du modulateur (6), l'optique de mise en forme du rayon (8) présentant de préférence la forme d'une lentille Powell (24).

6. Dispositif selon l'une des revendications 1 à 5, **caractérisé en ce**
   **que** l'optique de réduction (10) présente un objectif de microscope (36) et/ou
   **que** l'optique de réduction (10) présente au moins deux objectifs ayant des distances focales et/ou des ouvertures numériques différentes et/ou que l'optique de réduction (10) présente un filtre de fréquence de lieu dans le plan de Fourier (37) ou à proximité de celui-ci.

7. Dispositif selon l'une des revendications 1 à 6, **caractérisé en ce**
   **que** le plateau de transport (12) est positionnable dans un axe, notamment dans deux axes, et/ou
   **que** le plateau de transport (12) déplace le support d'enregistrement (2) en direction de l'optique de réduction (10).

8. Dispositif selon l'une des revendications 1 à 7, **caractérisé en ce**
   **qu'**il est prévu un élément optique mobile (38) dans l'entrée du rayon avant l'optique de réduction afin de déplacer le modèle d'intensité réduit sur le support d'enregistrement et/ou
   **qu'**il est prévu un système de caméra (40) pour contrôler la microstructuration ou pour contrôler une orientation prédéfinie ou un alignement par rapport à une microstructuration ou un marquage prédéfini (e) ou déjà écrit(e) et/ou
   **qu'**il est prévu un système de mise au point automatique (42) pour adapter l'espacement du support d'enregistrement (2) de l'optique de réduction (10).

9. Procédé de commande d'un dispositif de microstructuration d'un support d'enregistrement selon l'une des revendications 1 à 8,

   - selon lequel, pendant le mouvement du plateau de transport, un déclencheur principal $T_0$ est gé-

néré à une durée $\Delta T$ prédéfinie avant d'atteindre la position d'une nouvelle structuration à écrire dans le support d'enregistrement,

- selon lequel la source de rayonnement est commandée pour générer une impulsion de rayonnement à l'instant $T_0 + \Delta T$,

- selon lequel le modulateur est réglé avant d'atteindre l'instant $T_0 + \Delta T$ conformément aux informations à écrire et

- selon lequel la source de rayonnement génère à l'instant $T_0 + \Delta T$ une impulsion de rayonnement dont la distribution d'intensité varie en fonction du réglage du modulateur.

10. Procédé selon la revendication 9,
selon lequel le plateau de transport est déplacé continuellement et selon lequel les déclencheurs principaux $T_0$ sont générés par le mouvement du plateau de transport à chaque fois d'un écart prédéfini.

11. Procédé de commande d'un dispositif de microstructuration d'un support d'enregistrement selon l'une des revendications 1 à 8,

- selon lequel une première piste de structuration est écrite dans une direction d'écriture dans le support d'enregistrement,

- selon lequel au moins une deuxième piste de structuration est écrite parallèlement à la première piste de structuration dans le support d'enregistrement et

- selon lequel l'au moins une deuxième piste de structuration est écrite en sens inverse de la direction d'écriture de la piste de structuration précédente.

12. Procédé selon la revendication 11,

- selon lequel le bord de la première piste de structuration est détecté à l'aide d'un dispositif de détection, notamment d'un système de caméra, et

- selon lequel le plateau de transport est déplacé transversalement par rapport à la direction d'écriture de telle sorte que la deuxième piste de structuration est écrite directement juxtaposée au bord de la première piste de structuration.

Fig.1

EP 2 005 251 B1

Fig.2

EP 2 005 251 B1

Fig.3

Höhe zunehmend

Belichtungskeil

Intensität
abnehmend
in 16 Stufen

Fokusfehlersignal

Arbeitspunkt

Fig. 4

EP 2 005 251 B1

Fig. 6

Fig. 5

EP 2 005 251 B1

Fig. 8

Fig. 7

29

Fig. 10

Fig. 9

Fig. 11

Fig. 12

rel. Intensität

Einzelpixel

Doppelpixel

Dreierpixel

Viererpixel

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 02079881 A
- WO 02079883 A
- WO 02084404 A
- WO 02084405 A
- WO 03012549 A
- DE 10137832
- WO 02084588 A
- WO 2005111913 A
- EP 1094352 A2
- DE 19802712 A1
- US 20050219502 A
- EP 1202550 A1
- EP 1480441 A1
- WO 0179935 A
- US 4826299 A